# EUROPEAN PATENT APPLICATION

(11) **EP 4 090 140 A1**
(43) Date of publication of application: **16.11.2022**
(21) Application number: 20911526.0
(22) Date of filing: 25.12.2020
(51) Int. Cl.: H05K 3/20, G06F 3/041, G06F 3/044, H05K 3/06, H05K 3/38

(54) **METHOD FOR MANUFACTURING WIRING BODY, PATTERN PLATE, AND WIRING BODY**

(30) Priority: 08.01.2020 JP 2020001733
(71) Applicant: Panasonic Intellectual Property Management Co., Ltd., Osaka-shi, Osaka 540-6207 (JP)
(72) Inventor: NIRENGI, Takayoshi, Osaka-shi, Osaka (JP); TAHARA, Hiroshi, Osaka-shi, Osaka (JP); AISAKA, Tsutomu, Osaka-shi, Osaka (JP)
(74) Representative: Grünecker Patent- und Rechtsanwälte PartG mbB
(86) International application number: PCT/JP2020/048901
(87) International publication number: WO 2021/140971

(57) **Abstract**

A manufacturing method of the present disclosure is a method for manufacturing a wiring body. The manufacturing method includes a growth process, a transfer process, and a peeling process. In the growth process, a conductive layer of a wiring body is grown on a catalyst provided on a pattern plate. In the transfer process, the conductive layer on the pattern plate is transferred to an insulator. In the peeling process, the conductive layer is peeled off from the pattern plate together with the insulator. When the wiring body is manufactured a plurality of times, the growth process, the transfer process, and the peeling process are repeatedly executed using the same pattern plate.

## Description

### TECHNICAL FIELD

The present disclosure generally relates to a manufacturing method of a wiring body, a pattern plate, and a wiring body. More specifically, the present disclosure relates to a manufacturing method of a wiring body used for, for example, a touch sensor or the like, a pattern plate that is applied to the manufacturing method, and the wiring body.

### BACKGROUND ART

PTL 1 describes a touch panel sensor capable of accurately forming a conductive wire having a small line width and reducing a risk of falling or peeling of the conductive wire. The touch panel sensor includes a support having a light-transmitting property and the conductive wire provided on the support. The conductive wire includes at least a conductive layer made of a conductive material. A conductor layer of the conductive wire is provided in a recess of the support.

### Citation List

### Patent Literature

PTL 1: Unexamined Japanese Patent Publication No. 2015-138286

### SUMMARY OF THE INVENTION

A manufacturing method according to one aspect of the present disclosure includes: a process of growing a first conductive layer of a first wiring body on a catalyst provided on a pattern plate; a process of transferring the first conductive layer on the pattern plate to a first insulator; a process of peeling the first conductive layer from the pattern plate together with the first insulator; a process of growing a second conductive layer of a second wiring body on the catalyst provided on the pattern plate; a process of transferring the second conductive layer on the pattern plate to a second insulator; and a process of peeling the second conductive layer from the pattern plate together with the second insulator.

A pattern plate according to one aspect of the present disclosure is applied to the above manufacturing method.

A wiring body according to one aspect of the present disclosure includes: an insulator having a recess; and a conductor having at least a part disposed in the recess, and the wiring body is provided with a gap between a side surface of the conductor and the recess of the insulator.

### Advantageous effect of invention

According to the present disclosure, there is an advantage that the quality of a wiring body can be stabilized.

### BRIEF DESCRIPTION OF THE DRAWINGS

Fig. 1A is a schematic external view of a touch sensor including a wiring body according to a first exemplary embodiment.
Fig. 1B is an external view in which the touch sensor is applied for in-vehicle use.
Fig. 2A is a sectional view of the main part of the wiring body.
Fig. 2B is a sectional view of the main part in a case where another insulator is formed on a front surface of the wiring body.
Fig. 2C is a sectional view of the main part of another example of the wiring body.
Fig. 3 is a view for describing a manufacturing method of the wiring body according to the first exemplary embodiment.
Fig. 4A is a schematic view of the main part of an organic EL display integrated with the touch sensor including the wiring body.
Fig. 4B is a schematic view of the touch sensor and its periphery in the organic EL display.
Fig. 5A is a schematic view of the main part of a liquid crystal display integrated with the touch sensor including the wiring body.
Fig. 5B is a schematic view of the touch sensor and its periphery in the liquid crystal display.
Fig. 5C is a schematic view of the touch sensor and its periphery in another example of the liquid crystal display.
Fig. 6 is an enlarged view of a mounting board including the wiring body.
Fig. 7A is a sectional view of the main part of a first modification of the wiring body.
Fig. 7B is a sectional view of the main part in a case where another insulator is formed on the front surface of the wiring body.
Fig. 7C is a sectional view of the main part in another example of the wiring body.
Fig. 7D is a sectional view of the main part in still another example of the wiring body.
Fig. 8 is a view for describing a manufacturing method of the first modification.
Fig. 9A is a sectional view of the main part of a pattern plate used for manufacturing a second modification of the wiring body.
Fig. 9B is a sectional view of the main part of another example of the pattern plate.
Fig. 10 is a view for describing a manufacturing method of a wiring body of the second modification.
Fig. 11A is a sectional view of the main part of a wiring body according to a second exemplary embodiment.
Fig. 11B is a sectional view of the main part in a case where a second conductive layer is formed in a recess of the wiring body.
Fig. 11C is a sectional view of the main part in a case where a blackened layer is formed on a part of a front surface of a conductor in the wiring body.
Fig. 11D is a sectional view of the main part in a case where another insulator is formed on a front surface of the wiring body.
Fig. 12 is a view for describing a manufacturing method of the wiring body according to the second exemplary embodiment.
Fig. 13A is a sectional view of the main part of a first modification of the wiring body.
Fig. 13B is a sectional view of the main part in a case where another insulator is formed on the front surface of the wiring body.
Fig. 13C is a sectional view of the main part in another example of the wiring body.
Fig. 13D is a sectional view of the main part in still another example of the wiring body.
Fig. 14 is a view for describing a manufacturing method of the first modification.
Fig. 15A is a sectional view of the main part of another modification in the wiring body.
Fig. 15B is a sectional view of the main part of still another modification in the wiring body.
Fig. 16 is a view illustrating a result of a peelability verification test.
Fig. 17 is a view illustrating a result of a transfer test.
Fig. 18 is a view illustrating a result of the transfer test.

### DESCRIPTION OF EMBODIMENT

### [First exemplary embodiment]

### (1) Outline

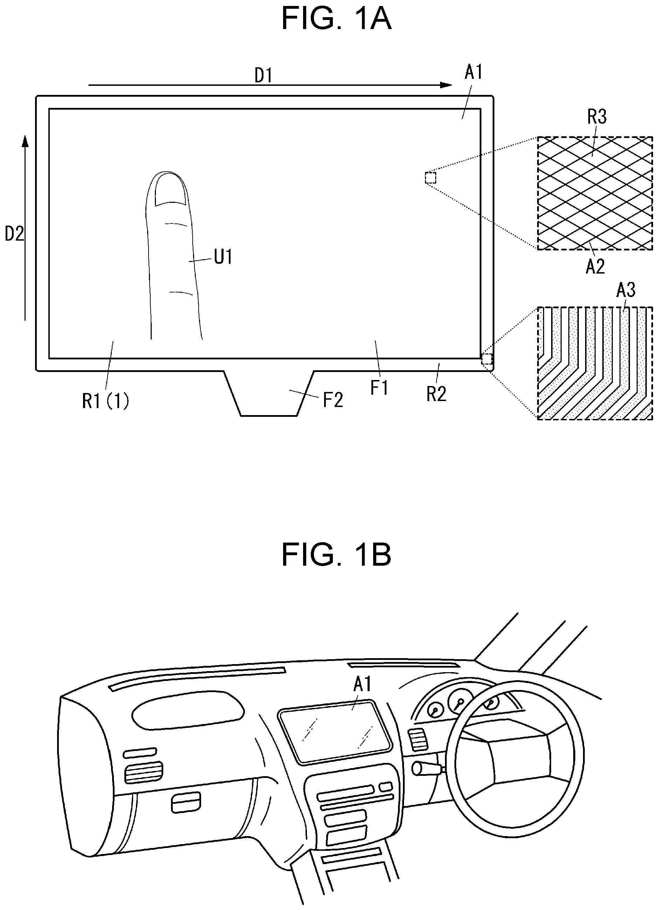

Hereinafter, a manufacturing method of wiring body 1 according to a first exemplary embodiment will be described with reference to Figs. 1A to 10. Each of the drawings described in the following first exemplary embodiment is a schematic view, and the ratio of the size and the thickness of each constituent element in each drawing does not necessarily reflect the actual dimensional ratio.

Here, it is assumed that wiring body 1 is applied to, for example, touch sensor A1 as illustrated in Figs. 1A and 1B. Touch sensor A1 is, for example, an electrostatic capacitance sensor, and senses a touch (contact) of operating body U1. Operating body U1 is, for example, a fingertip (a part of a living body) of a person. Operating body U1 may include an object (for example, a glove) covering a part of the living body, or may include an object (for example, a pen-type operating member) held by the living body. Touch sensor A1 may perform not only the sensing of touch of operating body U1 but also sensing of proximity thereof by enhancing the sensitivity.

Touch sensor A1 may be, for example, a film sensor of a so-called out-cell system. Touch sensor A1 is mounted on a liquid crystal panel in an electronic device and can be used as an operation unit that receives an operation input with respect to the electronic device. Examples of the electronic device include not only an in-vehicle center console but also a smartphone, a tablet terminal, a notebook personal computer (PC), and a car navigation system as illustrated in Fig. 1B. In addition, touch sensor A1 may be integrally incorporated in a display in an on-cell system or an in-cell system.

As illustrated in Fig. 1A, touch sensor A1 includes film body F1 having sensor electrode A2 that is linear and formed in a mesh shape using a thin metal wire. Here, it is assumed that wiring body 1 constitutes a part or whole of film body F1 having mesh-shaped sensor electrode A2 as an example.

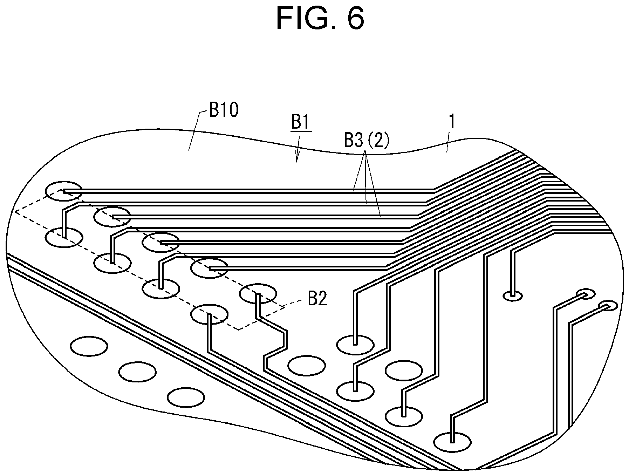

However, wiring body 1 according to the present exemplary embodiment is not limited to being applied to touch sensor A1, and may be applied to mounting board B1, for example, as illustrated in Fig. 6.

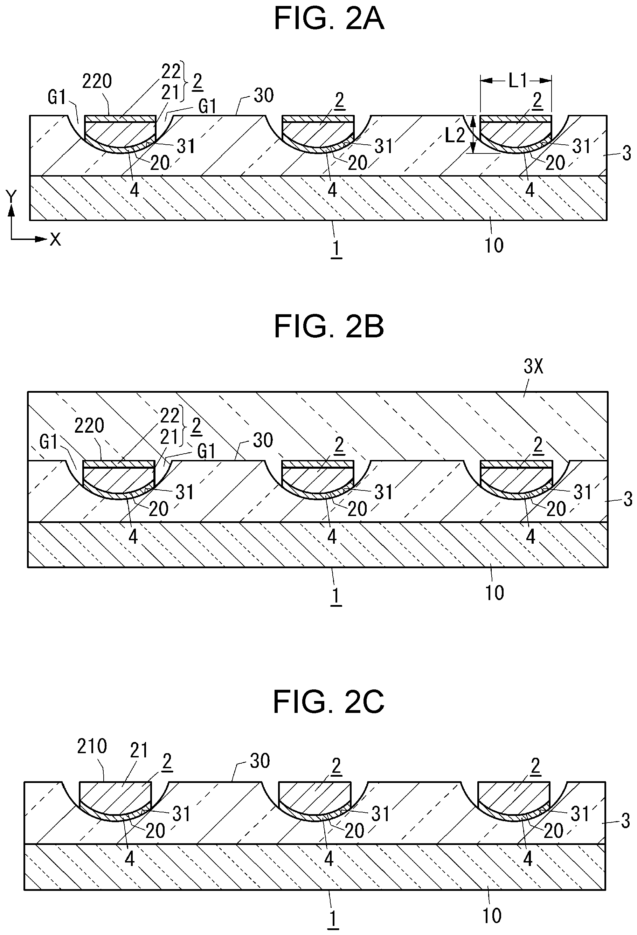

As illustrated in Figs. 2A and 2B, wiring body 1 includes conductor 2 and insulator 3. Here, conductor 2 constitutes sensor electrode A2 described above, and insulator 3 constitutes a part of film body F1. Figs. 2A and 2B are schematic sectional views of a main part taken along a plane orthogonal to a longitudinal direction of conductor 2 (sensor electrode A2).

Conductor 2 is disposed so as to be at least partially (substantially entirely in the example of Fig. 2A) embedded in front surface 30 of insulator 3. In the illustrated example, insulator 3 has grooves G1 recessed from front surface 30 around contact portion 20 of conductor 2 in contact with insulator 3. Here, as an example, grooves G1 are formed, respectively, on both sides (left and right sides in Fig. 2A) of contact portion 20 in the width direction.

That is, insulator 3 has accommodating part 31 (recess) recessed from front surface 30. Conductor 2 is disposed in accommodating part 31 (recess) of insulator 3. Then, a width of conductor 2 is narrower than a width of accommodating part 31 (recess) of insulator 3, and a gap is formed between a side surface of conductor 2 and insulator 3. Hereinafter, this gap corresponds to groove G1.

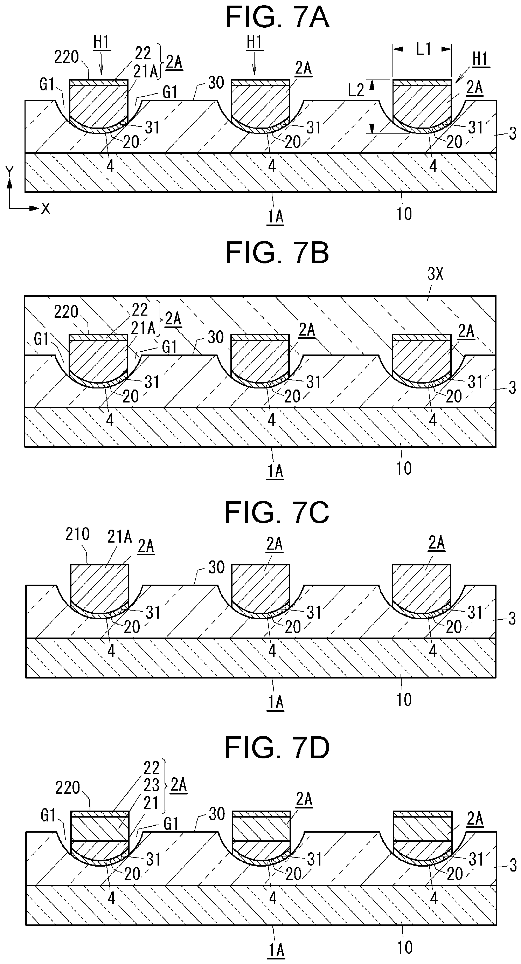

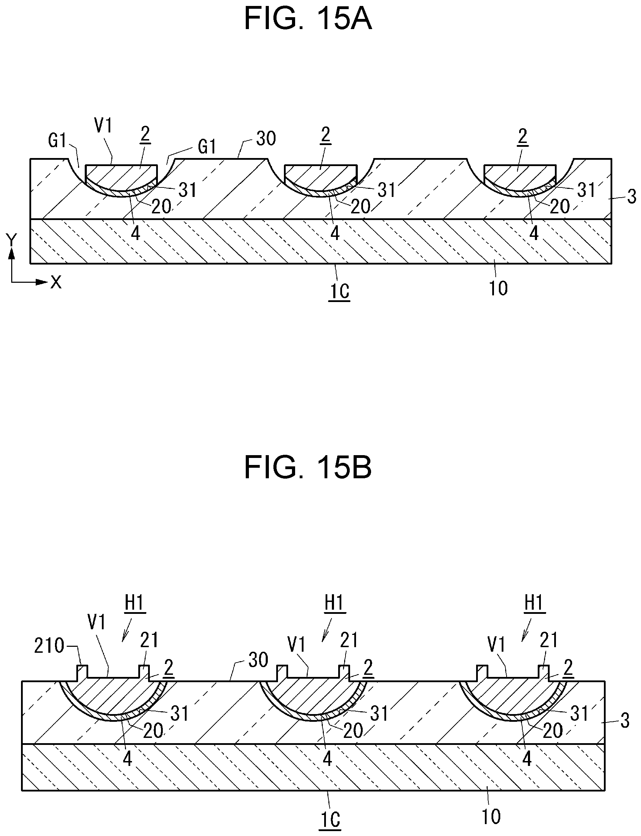

Note that front surface 30 of insulator 3 and front surface 220 of conductor 2 are located at the same height in the present exemplary embodiment, but are not necessarily located at the same height. For example, as illustrated in Fig. 7A, front surface 220 of conductor 2A may be located higher than front surface 30 of insulator 3. For example, as illustrated in Fig. 15A, the front surface of conductor 2 may be located lower than front surface 30 of insulator 3.

Note that accommodating part 31 of insulator 3 may be referred to as a "recess" in the present disclosure.

Since insulator 3 has groove G1 according to this configuration, a part of insulator 3X enters groove G1 when insulator 3X (a resin layer) different from insulator 3 is formed on insulator 3 as illustrated in Fig. 2B. As a result, insulator 3X is hardly repelled, and insulator 3X is hardly peeled off from conductor 2 and insulator 3. Therefore, wiring body 1 according to the present exemplary embodiment has an advantage that adhesion can be improved.

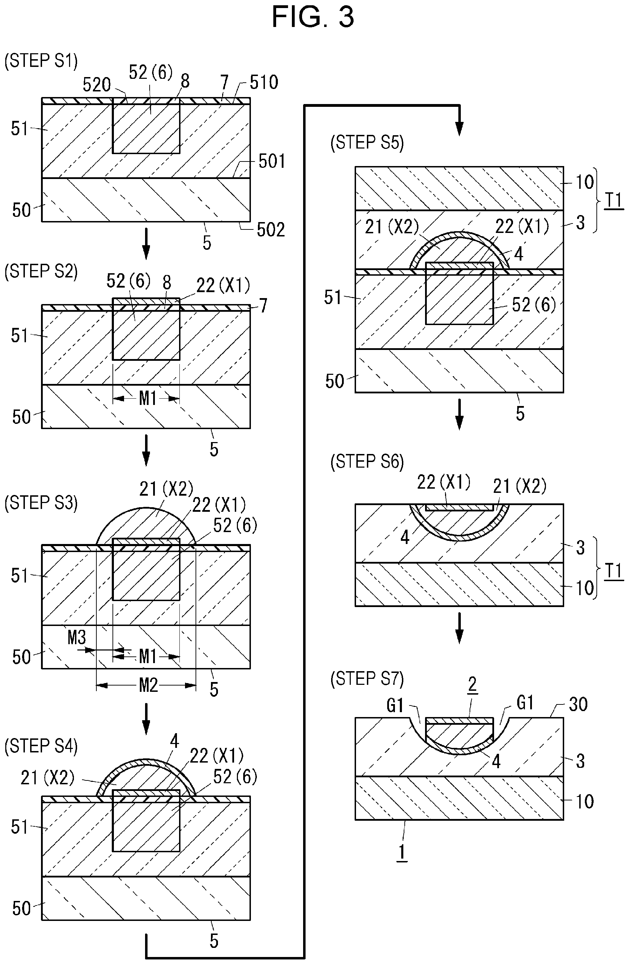

Here, the manufacturing method according to the present exemplary embodiment includes a growth process, a transfer process, and a peeling process. In the growth process, conductive layer X1 of wiring body 1 is grown on catalyst 6 provided on pattern plate 5 (see Fig. 3). In the transfer process, conductive layer X1 on pattern plate 5 is transferred to insulator 3. In the peeling process, conductive layer X1 is peeled off from pattern plate 5 together with insulator 3. When a plurality of wiring bodies 1 are manufactured, the growth process, the transfer process, and the peeling process are repeatedly executed using the same pattern plate 5.

According to this configuration, the manufacturing method includes the growth process, the transfer process, and the peeling process, and these processes are repeatedly executed using the same pattern plate 5, and thus, the quality of wiring body 1 can be stabilized.

### (2) Details

### (2.1) Overall configuration of touch sensor

First, an overall schematic configuration of touch sensor A1 (see Fig. 1A) according to the present exemplary embodiment will be described. As described above, touch sensor A1 can sense a touch of operating body U1 (such as a fingertip of a person). Touch sensor A1 includes wiring body 1 according to the present exemplary embodiment.

As illustrated in Fig. 1B, touch sensor A1 is mounted on a liquid crystal panel in an in-vehicle center console (electronic device), for example, and can be used as the operation unit.

As illustrated in Fig. 1A, touch sensor A1 is formed in, for example, a substantially rectangular shape when viewed from the front thereof. A region of touch sensor A1 in a plan view includes a sensor region R1 capable of sensing a touch of operating body U1 and a wiring region R2 (frame part) disposed around sensor region R1. In sensor region R1, a plurality of linear sensor electrodes A2 are arranged. Here, sensor electrode A2 is formed in a mesh shape as described above. On the other hand, in wiring region R2, a plurality of wirings A3 that output a change in electrostatic capacitance, which can occur between operating body U1 and sensor electrode A2, as an electric signal to a controller of the electronic device are arranged.

Conductor 2 of wiring body 1 constitutes sensor electrode A2. That is, wiring body 1 mainly constitutes sensor region R1 of touch sensor A1. However, conductor 2 may constitute wiring A3 without being limited to only sensor electrode A2. In other words, conductor 2 may constitute at least one of sensor electrode A2 that senses a touch and wiring A3 that is electrically connected to sensor electrode A2 and outputs an electric signal to the outside.

Touch sensor A1 is, for example, a self-capacitance sensor that senses a change in electrostatic capacitance between sensor electrode A2 and operating body U1. In a case where operating body U1 is an object having a ground potential such as a finger of a person, a pseudo capacitor is formed by a contact (touch) of touch sensor A1, and this contact appears as a change in electrostatic capacitance.

Specifically, touch sensor A1 includes film body F1 and flexible wiring board F2 as illustrated in Fig. 1A. Flexible wiring board F2 is bonded to a lower edge of film body F1, for example. Flexible wiring board F2 is electrically connected to an input terminal on the electronic device side. Film body F1 is, for example, a mesh-type transparent conductive film body, and includes a plurality of sensor electrodes A2 corresponding to conductors 2 and a plurality of wirings A3 as described above. Film body F1 has flexibility. In addition, film body F1 further includes base material 10 for holding sensor electrodes A2, insulator 3 (a resin layer), insulator 3X (the resin layer), and the like, but these constituent elements will be described in detail in the next section "(2.2) Wiring body and manufacturing method".

Touch sensor A1 may include only one film body F1 or two film bodies F1. That is, touch sensor A1 may include a double-sided film including two film bodies F1. Specifically, two film bodies F1 include a first film body including a plurality of sensor electrodes A2 functioning as transmission electrodes (Tx), and a second film body including a plurality of sensor electrodes A2 functioning as reception electrodes (Rx).

In the first film body, each sensor electrode A2 corresponding to transmission electrode (Tx) constitutes, for example, a mesh-shaped detector extending along first direction D1 (the lateral direction in Fig. 1A). In each detector, a plurality of regions R3 (see Fig. 1A) having substantially rhombic shapes and surrounded by thin metal wires are arranged along first direction D1. Then, a plurality of the detectors are arranged side by side along second direction D2 (the vertical direction in Fig. 1A).

In the second film body, each sensor electrode A2 corresponding to reception electrode (Rx) constitutes, for example, a mesh-shaped detector extending along second direction D2. In each detector, a plurality of substantially rhombic regions (not illustrated in Fig. 1A) surrounded by thin metal wires are arranged along second direction D2. Then, a plurality of the mesh-shaped detectors are arranged side by side along first direction D1.

In touch sensor A1, two film bodies F1 are bonded to each other with a longitudinal direction of the plurality of transmission electrodes (Tx) in the first film body being oriented in an X-axis direction and a longitudinal direction of the plurality of reception electrodes (Rx) in the second film body being oriented in a Y-axis direction. As a result, it is possible to perform sensing of a touch position of operating body U1 with respect to the X-axis direction and sensing of the touch position of operating body U1 with respect to the Y-axis direction. However, touch sensor A1 may include a single-sided film including one film body F1.

For example, assuming that touch sensor A1 is mounted on a liquid crystal panel having a relatively large screen, it is desirable that touch sensor A1 be made of a material capable of achieving low resistance even in sensor region R1 having a large size.

### (2.2) Wiring body and manufacturing method thereof

Wiring body 1 constituting sensor region R1 of touch sensor A1 in the present exemplary embodiment, and a manufacturing method thereof will be described in detail with reference to Figs. 2A to 3. Numerical values (dimensions and the like) disclosed hereinafter are merely examples, and are not limited.

### [Structure of wiring body]

As illustrated in Fig. 2A, wiring body 1 includes a plurality of conductors 2 constituting sensor electrodes A2, insulator 3, and base material 10. Fig. 2A illustrates a sectional view of only a part of wiring body 1, and particularly illustrates only three conductors 2 for convenience of the description. Each conductor 2 corresponds to one of the metal thin wires forming the plurality of regions R3 (see Fig. 1A) having substantially rhombic shapes. Fig. 2A is a schematic sectional view of wiring body 1 taken along a plane orthogonal to the longitudinal direction of each conductor 2 (metal thin wire). In Fig. 2A, three conductors 2 are arranged in the lateral direction at substantially equal intervals.

Hereinafter, as an example, two axes of an X axis and a Y axis, which are orthogonal to each other, are set as illustrated in Fig. 2A, and particularly, a direction along an array direction in which the three conductors 2 are arranged is referred to as the "X-axis" direction, and a direction along a thickness direction of insulator 3 is referred to as the "Y-axis" direction. The longitudinal direction of conductor 2 is a direction orthogonal to both the X-axis direction and the Y-axis direction. The X axis and the Y axis are all virtual axes, and arrows indicating "X" and "Y" in the drawings are merely described for the sake of description, and are not accompanied by real entities. In addition, these directions are not intended to limit directions when wiring body 1 is used. In addition, a description will be given by paying attention to one conductor 2 unless otherwise specified.

Conductor 2 is a portion having conductivity. Conductor 2 has a substantially rectangular cross section that is elongated along the X-axis direction. That is, a thickness direction of conductor 2 extends along the Y-axis direction. Conductor 2 is disposed so as to be substantially entirely embedded in front surface 30 of insulator 3. That is, insulator 3 has accommodating part 31, configured to accommodate conductor 2, on front surface 30. The accommodating part 31 is formed to be recessed from front surface 30. A sectional area of accommodating part 31 is substantially equal to a sectional area of conductor 2.

Insulator 3 is a portion having an electrical insulation property. Insulator 3 is, for example, a resin layer. Insulator 3 is made of a light-transmissive resin or the like. The thickness direction of insulator 3 extends along the Y-axis direction. Insulator 3 has the pair of grooves G1 recessed from front surface 30 around contact portion 20 of conductor 2 in contact with insulator 3, here, on both sides of conductor 2 in the X-axis direction. In other words, the pair of grooves G1 is provided on both sides of accommodating part 31 in the X-axis direction, and accommodating part 31 and the pair of grooves G1 constitute one dent having a substantially semicircular cross section. Here, contact portion 20 of conductor 2 with insulator 3 corresponds to an end surface (curved surface) in the negative direction of the Y axis. Contact portion 20 has a substantially arcuate cross section.

Both side surfaces of conductor 2 in the X-axis direction oppose inner side surfaces of insulator 3, respectively, with the pair of grooves G1 interposed therebetween. That is, both the side surfaces of conductor 2 are not in contact with insulator 3.

Base material 10 is a portion that supports conductor 2 and insulator 3. Base material 10 is a plate material having a light-transmitting property, and is made of, for example, glass, a light-transmissive resin, or the like. A thickness direction of base material 10 extends along the Y-axis direction. Insulator 3 is stacked on a front surface of base material 10 in the positive direction of the Y axis.

In addition, wiring body 1 of the present exemplary embodiment further includes adhesion layer 4 which has adhesion and is disposed at an interface between insulator 3 and conductor 2. Then, contact portion 20 is in contact with insulator 3 via adhesion layer 4.

In addition, conductor 2 of the present exemplary embodiment has a two-layer structure. Specifically, conductor 2 includes conductive layer 21 having contact portion 20, and conductive layer 22 disposed on a side of conductive layer 21 opposite to contact portion 20. Conductive layer 22 is stacked on a front surface of conductive layer 21 in the positive direction of the Y axis. Front surface 220 of conductive layer 22 in the positive direction of the Y axis is substantially flush with front surface 30 of insulator 3.

Conductive layer 21 is made of copper or an alloy of copper nickel (CuNi). A thickness of conductive layer 21 is, for example, about 1 µm to 1.5 µm.

Conductive layer 22 is formed as a layer containing nickel and boron (for example, a NiB layer). A thickness of conductive layer 22 is, for example, about 0.3 µm. Therefore, conductive layer 22 is a layer different in material from conductive layer 21.

That is, conductor 2 contains nickel. In other words, conductor 2 contains nickel in at least one layer of conductive layer 21 and conductive layer 22. Thus, reliability (conductivity, corrosion resistance, and the like) of conductor 2 can be improved.

Here, adhesion layer 4 is an oxide of copper. Adhesion layer 4 is assumed to be, for example, copper oxide (CuO), but is not limited to copper oxide (CuO) as long as being an oxide of copper. In addition, adhesion layer 4 corresponds to a blackened layer. When a blackening treatment is performed on a part of the front surface (contact portion 20) of conductive layer 21, the part becomes the blackened layer (adhesion layer 4). In short, since adhesion layer 4 is an oxide of copper, black can be imparted to wiring body 1, and reflection can be reduced. As a result, the possibility that the visibility is impaired can be reduced, for example, when wiring body 1 is applied to touch sensor A1 as in the present exemplary embodiment.

Line width L1 (dimension in the X-axis direction) of conductor 2 is, for example, about 2 µm. Thickness L2 (dimension in the Y-axis direction) of conductor 2 including a thickness of adhesion layer 4 is, for example, about 1 µm to 2 µm.

Meanwhile, conductor 2 having the two-layer structure is merely an example. For example, as illustrated in Fig. 2C, conductor 2 may include only conductive layer 21. In this case, a thickness dimension of conductive layer 21 is set such that front surface 210 of conductive layer 21 is substantially flush with front surface 30 of insulator 3.

In this manner, insulator 3 has grooves G1 recessed from front surface 30 on both the sides of conductor 2 in the present exemplary embodiment. Thus, in a case where film body F1 is manufactured by forming insulator 3X (the resin layer) different from insulator 3 on front surface 30 of insulator 3, for example, as illustrated in Fig. 2B, a resin material enters (bites into) groove G1 at the time of forming insulator 3X. In other words, the resin material of insulator 3X is hardly repelled. In addition, even after the formation of insulator 3X, a contact area between insulator 3X and conductor 2 and insulator 3 increases, and insulator 3X is hardly peeled off from conductor 2 and insulator 3. Thus, wiring body 1 according to the present exemplary embodiment has an advantage that adhesion can be improved.

Note that insulator 3 may have groove G1 only on any one side without being limited to having grooves G1 on both the sides of conductor 2.

### [Manufacturing method of wiring body]

Next, the manufacturing method of wiring body 1 will be described with reference to Fig. 3.

As illustrated in Fig. 3, the manufacturing method of wiring body 1 includes steps S1 to S7. However, the number of steps is not limited to seven. The manufacturing method of wiring body 1 may further include other steps in addition to steps S1 to S7.

Wiring body 1 of the present exemplary embodiment can be manufactured, for example, in the order of steps S1 to S7. However, the manufacture of wiring body 1 is not strictly limited to being executed in the order of steps S1 to S7. In addition, a description regarding a finishing process and the like performed after step S7 is omitted here.

Although only one conductor 2 is illustrated in Fig. 3 since the description is given by paying attention to only one conductor 2, wiring body 1 including a plurality of conductors 2 can be formed through steps S1 to S7.

Here, wiring body 1 of the present exemplary embodiment is manufactured using pattern plate 5. First, a configuration of pattern plate 5 will be described. The manufacturing method of the present exemplary embodiment includes a process of performing, for example, electroless plating using pattern plate 5 to precipitate metal on the front surface and grow a conductive layer of conductor 2.

Pattern plate 5 has a rectangular sheet shape as a whole. As illustrated in step S1 of Fig. 3, pattern plate 5 includes base material 50, adhesive layer 51, parent material 52 (catalyst 6), resin layer 7, and organic film 8.

Base material 50 is a portion that supports adhesive layer 51 and parent material 52. Base material 50 is, for example, a rectangular plate material having a light-transmitting property, and is made of glass or a resin. Base material 50 has first surface 501 (front surface) that is flat and second surface 502 (back surface) that is flat as both end surfaces in its thickness direction.

Adhesive layer 51 is a portion that fixes parent material 52 to base material 50. Adhesive layer 51 has an electrical insulation property (serves as a first insulating layer). Adhesive layer 51 is made of, for example, a resin (adhesive) having a light-transmitting property. Adhesive layer 51 is stacked on first surface 501 of base material 50. Adhesive layer 51 is formed so as to cover a surface other than front surface 520 of parent material 52. In other words, parent material 52 is embedded in adhesive layer 51 in a form in which front surface 520 is exposed from adhesive layer 51. Front surface 510 of adhesive layer 51 is substantially flush with front surface 520 of parent material 52.

Parent material 52 is a portion configured to promote the electron transfer reaction between a reducing agent and a metal salt in the vicinity of parent material 52 by a catalyst mechanism and take out metal from a plating solution, that is, to precipitate metal on parent material 52 in manufacturing processes of wiring body 1. That is, parent material 52 is a portion that functions as catalyst 6.

Parent material 52 is made of a metal having conductivity to such an extent that electroplating can be performed in the manufacturing processes of wiring body 1. A material of parent material 52 is, for example, an alloy of iron and nickel. Parent material 52 is made of an alloy that has a total content of iron and nickel being more than or equal to 80%, and contains 80% nickel with respect to 20% iron as a ratio between nickel and iron. However, parent material 52 may be made of, for example, an alloy containing 60% nickel with respect to 40% iron or an alloy containing 40% nickel with respect to 60% iron without being limited to such a ratio.

Resin layer 7 is a layer having easy peelability. Resin layer 7 is disposed in a region other than a region of pattern plate 5 where catalyst 6 is provided. That is, resin layer 7 is stacked on adhesive layer 51. Resin layer 7 has an electrical insulation property (serves as a second insulating layer). That is, pattern plate 5 has insulating layers having a two-layer structure (adhesive layer 51 as the first insulating layer and resin layer 7 as the second insulating layer). Resin layer 7 is made of, for example, a fluorine-based resin. Note that resin layer 7 may be made of a silicon-based resin.

A method for forming pattern plate 5 will be briefly described as follows.

For example, a pattern of a dry film resist (DFR) is formed on a substrate. Then, an electrolytic Fe-Ni plating treatment is performed to peel off the DFR, so that only parent material 52 remains on the substrate. Base material 50 is attached to the substrate on which parent material 52 has been formed by using an adhesive which is to form adhesive layer 51. Then, base material 50, parent material 52, and adhesive layer 51 are peeled off from the substrate.

Furthermore, a photosensitive water-repellent material (here, a fluorine-based resin), which is to be a material of resin layer 7, is applied onto front surface 510 of adhesive layer 51 and front surface 520 of parent material 52. Then, base material 50 is irradiated with ultraviolet light (UV light) from a side (back side) of second surface 502. The UV light passes through base material 50 and adhesive layer 51, and thus, the photosensitive water-repellent material on front surface 510 of adhesive layer 51 is cured. On the other hand, the photosensitive water-repellent material on front surface 520 of parent material 52 is shielded from the UV light by parent material 52 so that the UV light to the extent of curing hardly reaches the photosensitive water-repellent material. As a result, the photosensitive water-repellent material on front surface 520 of parent material 52 is uncured. Thereafter, pattern plate 5 is washed with a solvent to remove the uncured photosensitive water-repellent material. Finally, resin layer 7 is formed on base material 50.

Organic film 8 is a ultrathin film having easy peelability. Organic film 8 is formed on parent material 52 (catalyst 6). Organic film 8 is made of, for example, a thiazole-based release agent. Organic film 8 also functions as a rust-proofing agent for parent material 52. A thickness dimension of organic film 8 is, for example, less than or equal to 100 nm.

The manufacturing method of wiring body 1 using the above pattern plate 5 will be described with reference to Fig. 3. Pattern plate 5 is applied to the manufacturing method of wiring body 1. Hereinafter, conductive layer 22 may be referred to as "conductive layer X1". In addition, conductive layer 21 may be referred to as "specific layer X2".

The manufacturing method of wiring body 1 according to the present exemplary embodiment includes the growth process, the transfer process, and the peeling process. In the growth process, conductive layer X1 of wiring body 1 is grown on catalyst 6 provided on pattern plate 5. In the transfer process, conductive layer X1 on pattern plate 5 is transferred to insulator 3. In the peeling process, conductive layer X1 is peeled off from pattern plate 5 together with insulator 3. When a plurality of wiring bodies 1 are manufactured, the growth process, the transfer process, and the peeling process are repeatedly executed using the same pattern plate 5. The manufacturing method of wiring body 1 according to the present exemplary embodiment further includes a release process, a blackening process, and a removal process (etching process), and these processes are also repeatedly executed together with the growth process, the transfer process, and the peeling process when the plurality of wiring bodies 1 are manufactured.

Hereinafter, the manufacturing method of wiring body 1 will be described in order from step S1 in Fig. 3.

Step S1 is the release process. In step S1, a release treatment is performed to form organic film 8 described above on parent material 52 (catalyst 6). When the release treatment is performed, conductive layer X1 (conductive layer 22) is easily removed from a mold, that is, peeled off from pattern plate 5 in the peeling process to be described later.

Step S2 is the growth process that is a process of growing conductive layer X1 (conductive layer 22) by electroless plating. In the present exemplary embodiment, the growth process further includes not only a first growth process of growing conductive layer X1 but also a second growth process of growing specific layer X2 (conductive layer 21) as another conductive layer on conductive layer X1. Step S2 corresponds to the first growth process, and the next step S3 corresponds to the second growth process of growing specific layer X2 by electroless plating.

In step S2 (the first growth process), conductive layer X1 is grown on parent material 52 having ultrathin organic film 8 formed on the front surface thereof by electroless plating. That is, pattern plate 5 is immersed in a plating solution in which a metal salt and a reducing agent coexist. Here, the electroless plating is performed by immersing pattern plate 5, subjected to step S1 (the release process), in a plating solution containing nickel, for example, an electroless Ni-B plating solution, so that the metal containing nickel is precipitated to form conductive layer X1. That is, here, the plating solution may contain a boron compound as a reducing agent. As a result, conductive layer 22 (conductive layer X1) containing nickel and boron is formed as described above.

It is not essential for conductive layer 22 to contain boron, and the plating solution may be, for example, an electroless Ni-P plating solution or an electroless Cu-Ni (copper nickel) solution other than the electroless Ni-B plating solution.

In addition, the plating solution containing nickel is applied here in consideration of peelability, but the plating solution is not limited to containing nickel. That is, conductive layer 22 may be formed by appropriate electroless plating, and conductive layer 22 may be formed using, for example, an electroless copper plating solution or an electroless silver plating solution.

Lateral width M1 of conductive layer X1 subjected to step S2 is substantially equal to a lateral width of parent material 52, and this is also substantially equal to line width L1 (about 2 µm) of conductor 2 of completed wiring body 1 illustrated in Fig. 2A.

In a case where conductive layer 22 (conductive layer X1) is omitted as illustrated in Fig. 2C, step S2 (the first growth process) is omitted.

In step S3 (the second growth process), specific layer X2 (conductive layer 21) is grown on conductive layer X1 by electroless plating, specifically, so as to cover conductive layer X1 and resin layer 7 in the vicinity of conductive layer X1. That is, in step S3 as well, pattern plate 5 is immersed in a plating solution in which a metal salt and a reducing agent coexist. Here, for example, pattern plate 5, subjected to step S2 (the first growth process), is immersed in an electroless Cu-Ni (copper nickel) plating solution to perform electroless plating, so that metal (copper nickel) is precipitated to form specific layer X2 of copper nickel. Specific layer X2 is formed to have a substantially semicircular cross section so as to cover conductive layer X1. Here, conductive layer X1 is thinner than specific layer X2. For example, a thickness of specific layer X2 is about 1 µm to 1.5 µm, whereas a thickness of conductive layer X1 is about 0.3 µm.

Lateral width M2 of specific layer X2 subjected to step S3 is larger than lateral width M1 of conductive layer X1, and is, for example, about 3 µm to 4 µm. Note that distance M3 from an edge of conductive layer X1 to an edge of specific layer X2 is, for example, about 0.5 µm to 1 µm.

In the case where step S2 (the first growth process) is omitted, pattern plate 5, subjected to the release treatment in step S1, is immersed. The plating solution in step S3 does not necessarily contain nickel, and may be an electroless Cu (copper) plating solution. In this case, specific layer X2 of copper is formed.

In the above example, conductive layer X1 and specific layer X2, which contain copper as metal having a relatively high conductivity, are formed, but conductive layer X1 and specific layer X2 may contain, for example, silver or gold instead of copper. In short, the plating solution is not limited to those described above.

Through the above growth process, conductive layer X1 can be stably formed. In particular, the two-layer structure can be stably achieved by the first growth process and the second growth process.

Step S4 is the blackening process. In step S4, a part of a front surface (surface layer) of specific layer X2, formed in step S3, is oxidized to form a blackened layer (that is, adhesion layer 4) which is an oxide of copper (here, a copper oxide). In other words, step S4 corresponds to a formation process of forming adhesion layer 4 having adhesion on a side of conductive layer X1 opposite to pattern plate 5 (here, on the front surface of specific layer X2 stacked on conductive layer X1). Adhesion layer 4 made of the copper oxide can be formed by, for example, immersing the surface layer of specific layer X2 in an appropriate oxidation treatment liquid to advance roughening of the front surface of specific layer X2. Adhesion layer 4 can be expected as a layer having a relatively high adhesion with respect to insulator 3 (the resin layer).

Note that the blackened layer (adhesion layer 4) is not limited to the copper oxide. The blackened layer may be formed by, for example, performing an etching treatment or the like on the surface layer of specific layer X2 to perform the roughening of the front surface, or may be formed by a plating treatment (for example, palladium substitution plating). Note that adhesion layer 4 is not an essential constituent element in the present disclosure. For example, if specific layer X2 itself is black, the blackened layer (adhesion layer 4) may be omitted. Since adhesion layer 4 is formed in this manner, conductive layer X1 is easily transferred to insulator 3 by adhesion layer 4 in the next transfer process. In addition, since the blackened layer (adhesion layer 4) is formed, it is possible to reduce the reflection in wiring body 1. Note that the blackened layer (adhesion layer 4) may be partially removed in a subsequent process.

Step S5 is the transfer process. In step S5, transfer member T1 is pressure-bonded to pattern plate 5 subjected to step S4, thereby transferring conductive layer X1, specific layer X2, and adhesion layer 4 to transfer member T1. Transfer member T1 is a member which is to serve as base material 10 and insulator 3 of (the completed) wiring body 1 illustrated in Fig. 2A. Transfer member T1 is pressed with a front surface (front surface 30) of a member corresponding to insulator 3 opposing pattern plate 5. As a result, conductive layer X1, specific layer X2, and adhesion layer 4 are embedded in the member corresponding to insulator 3 of transfer member T1.

Step S6 is the peeling process. In step S6, transfer member T1 is peeled off from pattern plate 5. As a result, conductive layer X1, specific layer X2, and adhesion layer 4 are fixed to transfer member T1 in an integrated manner. At this time, transfer member T1 can be easily peeled off from pattern plate 5 since pattern plate 5 is provided with resin layer 7 and organic film 8 having easy peelability as described above. In other words, excessive stress is hardly applied to transfer member T1 and pattern plate 5, transfer member T1 can be substantially uniformly peeled off, and conductive layer X1, specific layer X2, and adhesion layer 4 can be prevented from partially remaining on pattern plate 5.

In particular, since resin layer 7 is made of the fluorine-based resin, options of materials for insulator 3 of transfer member T1, adhesive layer 51 of pattern plate 5, and the like can be increased when the peelability is considered.

Step S7 is the removal process (etching process). In step S7, an etching treatment is performed on front surface 30 of insulator 3 to form grooves G1 on both sides of conductor 2. That is, the removal process is a process of removing a part of specific layer X2. Here, selective etching is performed to remove a part of specific layer X2 (and a part of adhesion layer 4), and conductive layer X1 and insulator 3 are maintained substantially intact without being removed. However, conductive layer X1 may also be partially removed, and the removal process may be a process of removing a part of conductive layer X1.

In particular, etching removal is performed by aeration of an etching solution in the removal process of the present exemplary embodiment. Here, for example, an aminebased etchant is used. The aeration is causing the etching solution to contain air (oxygen). For example, the aeration can be performed by spraying the etching solution onto front surface 30 of insulator 3. Specifically, in a place where the fluidity of the etching solution is high, the etching removal proceeds since the oxygen concentration is sufficiently secured in the etching solution. However, in a place where the fluidity of the etching solution is low, the etching removal hardly proceeds because it is difficult to sufficiently secure the oxygen concentration.

Such a difference in the fluidity is controlled so that a part of specific layer X2 (and a part of adhesion layer 4) protruding to both sides from conductive layer X1 is eroded earlier than conductive layer X1 when conductive layer X1 (conductive layer 22) is viewed from the positive side in the Y-axis direction (when viewed from above in Fig. 3). As a result, conductive layer X1, a portion substantially overlapping conductive layer X1 in specific layer X2 (when viewed from the positive side in the Y-axis direction), and a portion substantially overlapping conductive layer X1 in adhesion layer 4 (when viewed from the positive side in the Y-axis direction) remain. Finally, conductor 2 as a whole has line width L1 (see Fig. 2A) having a dimension substantially equal to lateral width M1 of conductive layer X1.

In short, groove G1 is a groove formed by removing a part of specific layer X2 (and a part of adhesion layer 4) by the etching treatment as an example here. This removal process can form groove G1 around specific layer X2, and, when another insulator 3X is formed on wiring body 1, the adhesion with insulator 3X can be improved. In particular, in the removal process, the progress by the etching removal can be easily controlled by the aeration of the etching solution.

Since conductor 2 has the two-layer structure (conductive layer 21 and conductive layer 22) in the present exemplary embodiment, it is easy to achieve two or more characteristics (for example, easy peelability and suitability for a blackening treatment).

In addition, the selective etching can be performed since conductor 2 has the two-layer structure in the present exemplary embodiment, and further, wiring body 1 including conductor 2 having a high aspect ratio can be provided by utilizing an effect of the aeration. The aspect ratio referred to herein is a dimension (lateral width) in the X-axis direction relative to a dimension (height) in the Y-axis direction in conductor 2. When conductor 2 having an aspect as high as possible, it is possible to contribute to a reduction in wiring resistance.

Then, the manufacturing method of wiring body 1 according to the present exemplary embodiment includes the growth process, the transfer process, and the peeling process, and these processes are repeatedly executed using the same pattern plate 5, and thus, the quality of wiring body 1 can be stabilized. In addition, wiring body 1 can be manufactured by repeatedly using the same pattern plate 5, which can contribute to cost reduction as a whole.

In addition, conductive layer X1 can be stably formed since conductive layer X1 (conductive layer 22) is grown by the electroless plating in the growth process. Furthermore, the growth process further includes not only the first growth process of growing conductive layer X1 but also the second growth process of growing specific layer X2 (conductive layer 21) as another conductive layer on conductive layer X1, and thus, the two-layer structure can be stably achieved. In particular, conductive layer X1 is thinner than specific layer X2, and thus, the two-layer structure can be more stably formed.

In addition, the quality of wiring body 1 can be stabilized since pattern plate 5 is applied to the manufacturing method of wiring body 1 in the present exemplary embodiment.

### (2.3) Application of wiring body

Hereinafter, the application of wiring body 1 will be described.

### [Organic EL display]

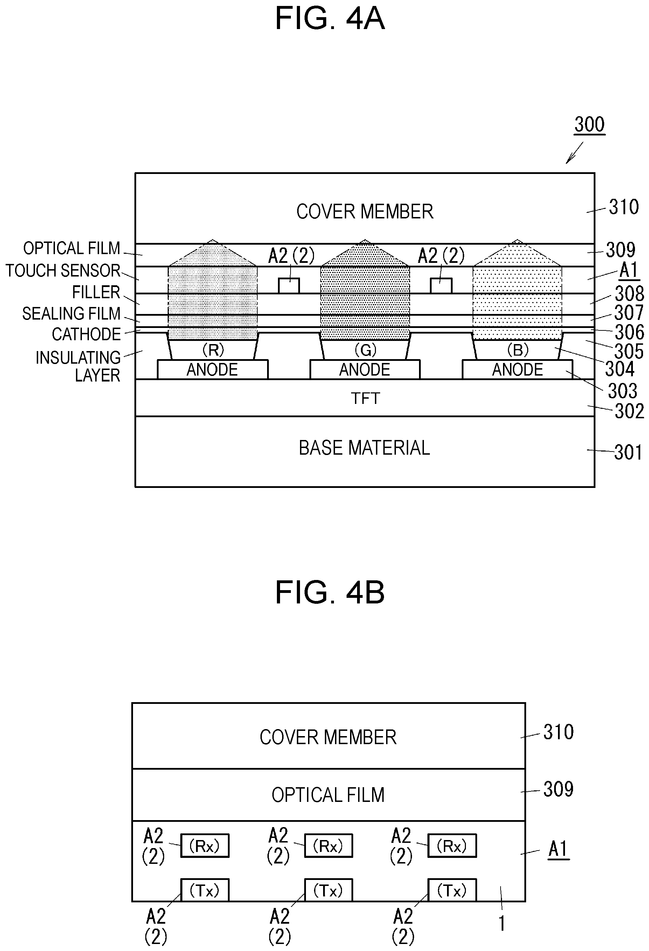

First, a case where touch sensor A1 (touch panel) including wiring body 1 according to the present exemplary embodiment is applied to organic electro-luminescence (EL) display 300 will be described with reference to Figs. 4A and 4B.

Fig. 4A is a schematic enlarged view illustrating a layer structure of organic EL display 300. Organic EL display 300 includes base material 301 such as glass, thin film transistor (TFT) 302, anodes (electrodes) 303, (organic EL) light emitting layers 304 of red (R), green (G), and blue (B), insulating layers 305, and cathode (electrode) 306. In addition, organic EL display 300 further includes sealing film 307, filler 308, touch sensor A1, optical film 309, and cover member 310 such as glass.

Touch sensor A1 including wiring body 1 is integrated with organic EL display 300. In particular, as illustrated in Fig. 4A, touch sensor A1 is disposed below optical film (polarizing film) 309 and above sealing film 307 and filler 308, and is integrated with organic EL display 300 in a so-called on-cell system.

In organic EL display 300, the front surface of conductor 2 is disposed so as to face light emitting layer 304. In other words, the blackened layer (adhesion layer 4) is disposed so as to face cover member 310. Therefore, deterioration in visibility from cover member 310 due to reflected light by conductor 2 is suppressed.

In organic EL display 300, two adjacent light emitting layers 304 among the plurality of (three in the illustrated example) RGB light emitting layers 304 are arranged at a predetermined interval as illustrated in Fig. 4A.

Here, in organic EL display 300, sensor electrode A2 (conductor 2) is disposed between two adjacent light emitting layers 304 so as to hardly overlap each layer of RGB light emitting layers 304 when viewed from the front side (the upper side in Fig. 4A). That is, sensor electrode A2 (conductor 2) is disposed so as to overlap insulating layer 305 interposed between two adjacent light emitting layers 304 when viewed from the front side. Thus, organic EL display 300 has an arrangement structure in which light emitted from each light emitting layer 304 is hardly blocked by conductor 2. Assuming that the above-described predetermined interval is, for example, 10 µm, line width L1 (see Fig. 2A) of conductor 2 is, for example, about 2 µm, and thus, the above-described arrangement structure can also be achieved.

In the case where touch sensor A1 is integrated with organic EL display 300 in the on-cell system in this manner, the above-described arrangement structure can be more easily achieved as compared with the out-cell system, and a display having a transmittance substantially close to 100% can be provided.

Fig. 4B is an enlarged schematic view of touch sensor A1 and its periphery. Touch sensor A1 may include a double-sided film including two film bodies F1. Specifically, two film bodies F1 include a first film body including a plurality of sensor electrodes A2 (conductors 2) functioning as transmission electrodes (Tx), and a second film body including a plurality of sensor electrodes A2 (conductors 2) functioning as reception electrodes (Rx) in an integrated manner.

"Insulator 3X (the resin layer) different from insulator 3" described in the above section "(2.2) Wiring body and manufacturing method thereof" may correspond to an insulator (resin layer) of the second film body that is formed on insulator 3 of the first film body in an integrated manner. Alternatively, "insulator 3X (the resin layer) different from insulator 3" may be a protective layer that protects the front surface of wiring body 1.

### [Liquid crystal display]

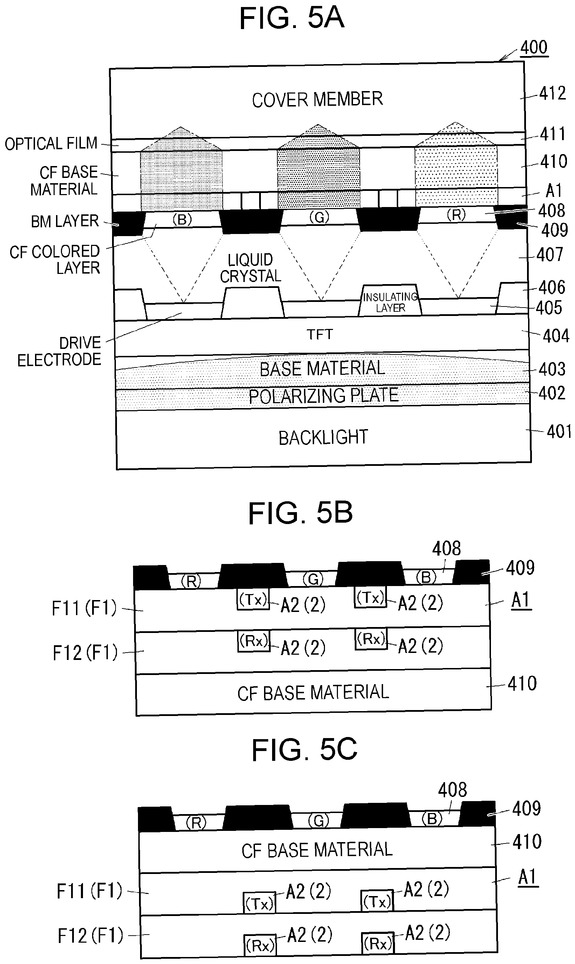

Next, a case where touch sensor A1 (touch panel) including wiring body 1 according to the present exemplary embodiment is applied to liquid crystal display 400 will be described with reference to Figs. 5A and 5B.

Fig. 5A is a schematic enlarged view illustrating a layer structure of liquid crystal display 400. Liquid crystal display 400 includes backlight 401, polarizing plate 402, base material 403 such as glass, TFT 404, drive electrodes 405, insulating layers 406, and liquid crystal 407. In addition, liquid crystal display 400 further includes color filter (CF) colored layers 408 of red (R), green (G), and blue (B), black matrix (BM) layers 409, touch sensor A1, CF base material 410, optical film 411, and cover member 412 such as glass.

Touch sensor A1 including wiring body 1 is integrated with liquid crystal display 400. In particular, as illustrated in Fig. 5A, touch sensor A1 is disposed below CF base material 410, and is integrated with liquid crystal display 400 in a so-called in-cell system.

In liquid crystal display 400, two adjacent CF colored layers 408 among the plurality of (three in the illustrated example) RGB CF colored layers 408 are arranged at a predetermined interval as illustrated in Fig. 5A.

Here, in liquid crystal display 400, sensor electrode A2 (conductor 2) is disposed between two adjacent CF colored layers 408 so as to hardly overlap each layer of the RGB CF colored layers 408 when viewed from the front side (the upper side in Fig. 5A). That is, sensor electrode A2 (conductor 2) is disposed so as to overlap BM layer 409 interposed between adjacent CF colored layers 408 when viewed from the front side. Thus, liquid crystal display 400 has an arrangement structure in which light emitted through each CF colored layer 408 is hardly blocked by conductor 2. Note that line width L1 (see Fig. 2A) of conductor 2 is, for example, about 2 µm assuming that the above-described predetermined interval is, for example, 10 µm, and thus, the above-described arrangement structure can also be achieved.

In the case where touch sensor A1 is integrated with liquid crystal display 400 in the in-cell system in this manner, the above-described arrangement structure can be more easily achieved as compared with the out-cell system, and a display having a transmittance substantially close to 100% can be provided.

Fig. 5B is an enlarged schematic view of touch sensor A1 and its periphery (and is vertically inverted from Fig. 5A). Touch sensor A1 may include a double-sided film including two film bodies F1 as illustrated in Fig. 5B. Specifically, two film bodies F1 include first film body F11 including a plurality of sensor electrodes A2 (conductors 2) functioning as transmission electrodes (Tx), and second film body F12 including a plurality of sensor electrodes A2 (conductors 2) functioning as reception electrodes (Rx) in an integrated manner. Note that the front surface of conductor 2 is disposed so as to face BM layer 409 in the example of Fig. 5B.

In addition, Fig. 5C is an enlarged schematic view of touch sensor A1 and its periphery (and is vertically inverted from Fig. 5A). Touch sensor A1 illustrated in Fig. 5C also includes the double-sided film including first film body F11 and second film body F12.

Here, touch sensor A1 illustrated in Fig. 5C is integrated with liquid crystal display 400 in a so-called on-cell system of being disposed above (below in Fig. 5C) CF base material 410, which is different from touch sensor A1 illustrated in Fig. 5A. Note that the front surface of conductor 2 is disposed so as to face a side opposite to BM layer 409 in the example of Fig. 5C.

### [Mounting board (semiconductor mounting board)]

Wiring body 1 according to the present exemplary embodiment is not limited to being applied to touch sensor A1. For example, as illustrated in Fig. 6, wiring body 1 may be applied to mounting board B1 (semiconductor mounting board).

At least one circuit component B2 is mounted on mounting board B1. Mounting board B 1 includes wiring body 1. Conductor 2 constitutes conductor pattern B3 to which circuit component B2 is electrically connected. Note that Fig. 6 illustrates back surface B10 of mounting board B 1, and circuit component B2 mounted on a front surface of mounting board B1 is indicated by an imaginary line in Fig. 6.

In this configuration as well, it is possible to provide mounting board B1 including wiring body 1 capable of improving adhesion.

### (2.4) Repeatability of pattern plate

Meanwhile, the manufacturing processes (steps S1 to S7) is repeatedly executed using the same pattern plate 5 as described above when a plurality of wiring bodies 1 according to the present exemplary embodiment are manufactured.

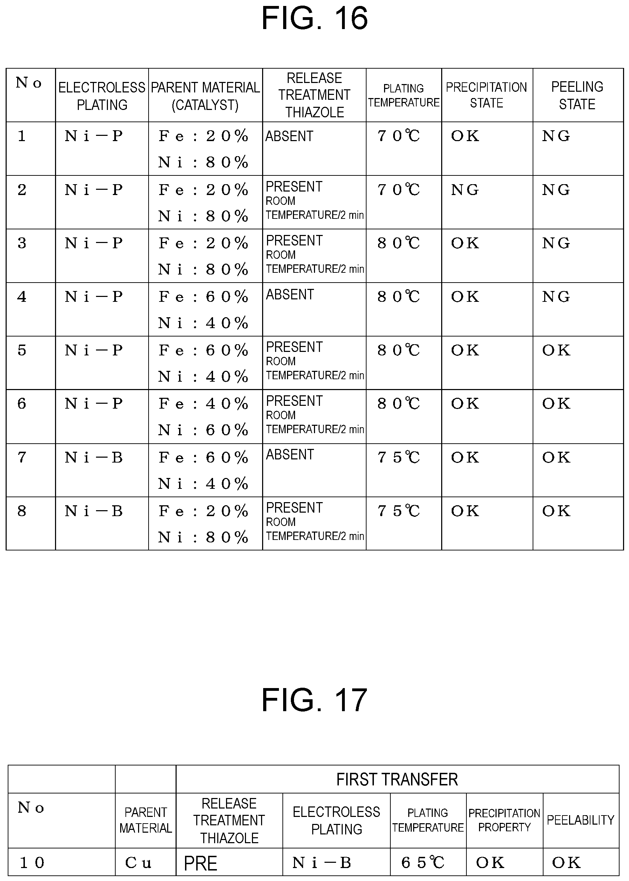

The inventors of the present invention have conducted tests to verify whether reuse of the same pattern plate 5 is actually possible. Specifically, "test plates" obtained by changing materials for a parent material (catalyst) and the like were prepared, and tests for verifying a precipitation property of electroless plating and peelability from the test plates were conducted while changing electroless plating solutions. Results thereof are illustrated in Fig. 16.

A release treatment (thiazole) illustrated in Fig. 16 is a treatment corresponding to step S1, and "Present" and "Absent" in the columns indicate the distinction between the presence and absence of organic film 8. In addition, "Room temperature/2 min" indicates an environment and a treatment time at the time of the release treatment.

In addition, the inventors of the present invention prepared a test plate using "Cu (copper)" for a parent material (catalyst), and performed a transfer test. Results thereof are illustrated in Fig. 17.

That is, when a parent metal was "Cu (copper)" and an electroless Ni-B plating solution was used, precipitation of "Ni-B" was possible, and the peelability was also good. Note that an electroless Ni-P plating solution was also used, but precipitation of "Ni-P" was not possible.

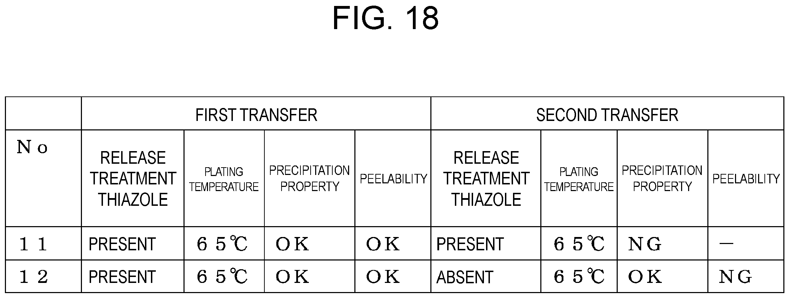

In addition, the inventors of the present invention prepared two test plates, and conducted the transfer test twice (two sets of tests of transferring and peeling) using each test plate. Results thereof are illustrated in Fig. 18. Note that in all the test plates, an alloy of "Fe: 60%, Ni: 40%" was used as a parent material (catalyst). In addition, as an electroless plating solution, an electroless Ni-B plating solution was used for both the first transfer and the second transfer in each test plate.

Here, the inventors further conducted a test of executing a "reset treatment" on the test plates under conditions equivalent to those of "No. 11", but between the first transfer and the second transfer. The reset treatment is "O₂ ashing", that is, a plasma ashing treatment using an oxygen gas (600 Watts, 90 sec). As a result, it was possible to confirm not only the repeatability of precipitation but also manifestation of the repeatability of peeling.

From the above tests, it has been confirmed that it is desirable to execute the reset treatment between whiles when a plurality of wiring bodies 1 are manufactured using the same pattern plate 5. In addition, it has been confirmed that it is desirable to form conductive layer 22 (NiB layer) as a plating film using the electroless Ni-B plating solution in consideration of the peelability and the increase in options for the parent material.

### (3) Modifications

The above-described first exemplary embodiment is merely one of various exemplary embodiments of the present disclosure. The first exemplary embodiment can be variously changed in accordance with design and the like as long as the object of the present disclosure can be achieved. Hereinafter, modifications of the first exemplary embodiment will be listed. Hereinafter, the first exemplary embodiment may be referred to as a "first basic example". Each modification to be described below can be applied by being appropriately combined with the first basic example or another modification.

### (3.1) First modification

Wiring body 1A according to the present modification (first modification) will be described with reference to Figs. 7A to 8. Hereinafter, constituent elements substantially common to wiring body 1 of the first basic example are denoted by the same reference marks, and descriptions thereof may be appropriately omitted. In addition, regarding a manufacturing method as well, descriptions of processes (steps) substantially common to those of the manufacturing method of wiring body 1 of the first basic example may be appropriately omitted.

In wiring body 1 of the first basic example, the front surface of conductor 2 (front surface 220 of conductive layer 22) is substantially flush with front surface 30 of insulator 3 in the Y-axis direction. Wiring body 1A of the present modification is different from wiring body 1 of the first basic example in that a front surface of conductor 2A protrudes from front surface 30 of insulator 3 in the Y-axis direction.

### [Structure of wiring body]

As illustrated in Fig. 7A, wiring body 1A of the present modification includes conductor 2A including conductive layer 21A and conductive layer 22, insulator 3, and base material 10.

Here, wiring body 1A includes protruding structure HI protruding from front surface 30 in a direction away from contact portion 20 on a side of conductor 2A opposite to contact portion 20 as illustrated in Fig. 7A. Conductive layer 21A of conductor 2A of the present modification has a larger dimension in the Y-axis direction than conductive layer 21 of conductor 2 of wiring body 1 of the first basic example. That is, protruding structure HI depending on a size (height with respect to a bottom of accommodating part 31) of conductive layer 21A is formed. Therefore, thickness L2 (dimension in the Y-axis direction) of conductor 2A is larger than thickness L2 of conductor 2 of the first basic example.

In this configuration as well, a resin material enters (bites into) the pair of grooves G1 at the time of forming insulator 3X as illustrated in Fig. 7B. In other words, the resin material of insulator 3X is hardly repelled. In addition, insulator 3X is hardly peeled off from conductor 2 and insulator 3 even after the formation of insulator 3X. Thus, wiring body 1A of the present modification also has an advantage that adhesion can be improved.

Furthermore, in this configuration, electric resistance (wiring resistance) can be reduced according to the volume of protruding structure HI. As a result, for example, when wiring body 1A is applied to touch sensor A1, it is easy to increase a size of the touch sensor.

In particular, when insulator 3 and insulator 3X are combined, there is a high possibility that the center of gravity of conductor 2 can be disposed at the midpoint of these resins since protruding structure HI is provided in this configuration. As a result, stress at the time of bending film body F1 is easily mitigated.

Note that conductor 2A is not limited to a two-layer structure, and conductor 2A may include only conductive layer 21A as illustrated in Fig. 7C, which is similar to wiring body 1 illustrated in Fig. 2C of the first basic example. In this case, front surface 210 of conductive layer 21A protrudes from front surface 30 of insulator 3 in the Y-axis direction.

Meanwhile, conductor 2A may include conductive layer 21 having contact portion 20, conductive layer 22 disposed on a side of conductive layer 21 opposite to contact portion 20, and conductive layer 23 as illustrated in Fig. 7D. Conductive layer 23 is interposed between conductive layer 21 and conductive layer 22. Protruding structure HI is configured using conductive layer 23. In short, conductor 2A illustrated in Fig. 7D is different from conductor 2 of the first basic example in terms of having a three-layer structure and conductive layer 23 being interposed between conductive layer 21 and conductive layer 22 in conductor 2 of the first basic example. In this case, conductive layer 23 contains copper and nickel. In this case, conductive layer 21 contains copper, but does not necessarily contain nickel, which is different from conductive layer 23. Conductive layer 22 is formed as a layer containing nickel and boron (for example, a NiB layer). In short, a material of conductive layer 23 is different from those of conductive layer 21 and conductive layer 22.

According to the configuration of conductor 2A illustrated in Fig. 7D, protruding structure HI is easily achieved. In addition, the three-layer structure enables selective etching. In particular, since conductive layer 23 contains copper and nickel, for example, when a part of conductive layer 23 is removed by etching by aeration of an etching solution, damage due to the etching solution can be suppressed. In addition, the electric resistance (wiring resistance) can be further reduced.

### [Manufacturing method of wiring body]

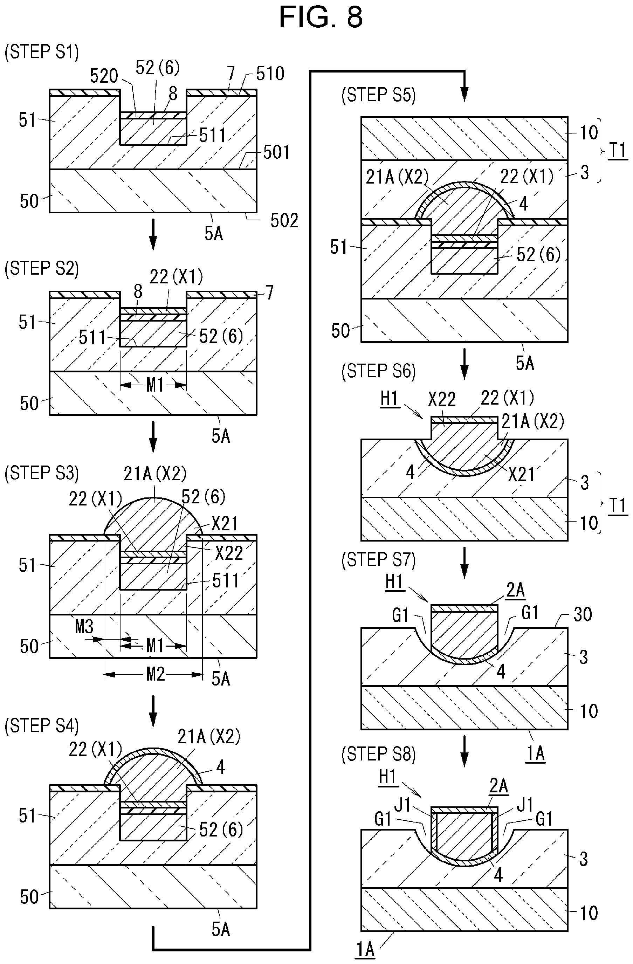

Next, a manufacturing method of wiring body 1A of the present modification will be described with reference to Fig. 8.

As illustrated in Fig. 8, the manufacturing method of wiring body 1A of the present modification includes steps S1 to S8. Wiring body 1A can be manufactured, for example, in the order of steps S1 to S8. However, the manufacture of wiring body 1A is not strictly limited to being executed in the order of steps S1 to S8.

Wiring body 1A of the present modification is manufactured using pattern plate 5A. Here, pattern plate 5A is formed such that front surface 520 of parent material 52 (catalyst 6) becomes lower in a direction of approaching base material 50 than front surface 510 of adhesive layer 51 in order to form protruding structure HI described above as compared with pattern plate 5 used in the manufacture of wiring body 1 of the first basic example. Note that a thickness of parent material 52 is set to be smaller than a thickness of parent material 52 (see Fig. 3) of the first basic example in the example of Fig. 8, but the thickness of parent material 52 may be set to be the same, and instead, a thickness of adhesive layer 51 and a depth of recessed portion 511 in which parent material 52 is accommodated may be increased.

In the present modification, organic film 8 formed on parent material 52 is also formed to be lower in the direction of approaching base material 50 than resin layer 7.

In short, pattern plate 5A has a recess structure to form protruding structure HI of wiring body 1 by setting front surface 520 of parent material 52 to a position lower than front surface 510 of adhesive layer 51. Therefore, pattern plate 5A can easily achieve the manufacture of wiring body 1 capable of reducing the electric resistance (wiring resistance).

The manufacturing method of wiring body 1A using the above pattern plate 5A will be described with reference to Fig. 8. Hereinafter, conductive layer 22 may be referred to as "conductive layer X1". In addition, conductive layer 21A may be referred to as "specific layer X2".

Step S1 is the release process. In step S1, a release treatment is performed to form organic film 8 described above on parent material 52 (catalyst 6).

In step S2 (the first growth process), conductive layer X1 is grown on parent material 52 having ultrathin organic film 8 formed on the front surface thereof by electroless plating.

In step S3 (a second growth process), specific layer X2 (conductive layer 21A) is grown on conductive layer X1 by electroless plating, specifically, so as to cover conductive layer X1 and resin layer 7 in the vicinity of conductive layer X1. Specific layer X2 is formed so as to cover conductive layer X1. Specifically, specific layer X2 includes umbrella part X21 having a substantially semicircular cross section, and base X22 that is narrower than umbrella part X21 below umbrella part X21 and has a substantially rectangular cross section. Umbrella part X21 is formed over resin layer 7 (so as to partially overlap an upper surface at an edge part of resin layer 7). Base X22 is buried in recessed portion 511.

Note that, when conductor 2A having the three-layer structure illustrated in Fig. 7D is manufactured, it is preferable to provide a step (third growth process) of growing conductive layer 23 by electroless plating between step S2 and step S3.

Step S4 is the blackening process. In step S4, a part of a front surface (surface layer) of specific layer X2, formed in step S3, is oxidized to form a blackened layer (that is, adhesion layer 4) which is an oxide of copper (here, a copper oxide).

Step S5 is the transfer process. In step S5, transfer member T1 is pressure-bonded to pattern plate 5A subjected to step S4, thereby transferring conductive layer X1, specific layer X2, and adhesion layer 4 to transfer member T1.

Step S6 is the peeling process. In step S6, transfer member T1 is peeled off from pattern plate 5A. As a result, conductive layer X1, specific layer X2, and adhesion layer 4 are fixed to transfer member T1 in an integrated manner. At this point, umbrella part X21 of specific layer X2 is embedded in insulator 3. On the other hand, base X22 protrudes from front surface 30 of insulator 3 as a portion constituting a part of protruding structure HI. A lateral width of base X22 (substantially equal to lateral width M1 of conductive layer X1) is narrower than a lateral width of umbrella part X21 (corresponding to lateral width M2 of specific layer X2).

Step S7 is the removal process (etching process). In step S7, an etching treatment is performed on front surface 30 of insulator 3 to form grooves G1 on both sides of conductor 2A.

Step S8 is a process that is not included in the manufacturing method of wiring body 1 of the first basic example. When step S4 is a first blackening process, step S8 is a second blackening process. In step S8, a surface layer of conductor 2A is immersed in an appropriate oxidation treatment solution. For example, in a case where conductive layer X1 is made of a metal containing nickel such as a nickel boron alloy and a blackening treatment in the second blackening process is an oxidation treatment of copper, nickel is not oxidized, and only copper on a side part of specific layer X2 can be blackened by the oxidation treatment (formation of blackened layer J1). In this case, the visibility when viewed from the front or side of wiring body 1A can be further improved, and a state having conductivity as a nickel alloy can be maintained at a connecting part with an input terminal of flexible wiring board F2. Thus, the connection with the input terminal becomes possible without requiring a process of removing a copper oxide or the like.

Meanwhile, for example, a nickel etching treatment may be performed on conductive layer X1 made of a metal containing nickel, and thereafter, the surface layer of conductor 2A may be immersed in an appropriate oxidation treatment solution in step S8. As a result, blackened layer J1 may be formed on the side surface of conductive layer 21A and a front surface of conductive layer 22. In this case, a front surface and a side surface of conductor 2A can be blackened, and further reduction of reflection can be achieved. Note that step S8 may also be applied to the manufacturing method of wiring body 1 of the first basic example. Blackened layer J1 may be partially removed in a subsequent step. For example, in a case where wiring body 1 constitutes wiring A3 of touch sensor A1, blackened layer J1 may be removed for the contact portion to cause a part of conductor 2 to function as a connection terminal in order to enhance reliability related to electrical contact with the input terminal of flexible wiring board F2.

Meanwhile, in step S6 of the present modification, umbrella part X21 of specific layer X2 is embedded in insulator 3. On the other hand, base X22 protrudes from front surface 30 of insulator 3 as a portion constituting a part of protruding structure HI. Here, step S7 (the removal process) may be omitted, and another insulator 3X may be formed on wiring body 1A in a state where conductor 2 includes umbrella part X21 and base X22, or application to film body F1 or the like of touch sensor A1 may be performed. In short, groove G1 is not an essential structure in wiring body 1A having the configuration in which conductor 2 includes umbrella part X21 and base X22 narrower than umbrella part X21. In this case, the blackened layer (adhesion layer 4) formed on a front surface of umbrella part X21 can cover the reflection of conductor 2 in a wider range, and the visibility is further improved. That is, when the etching removal is omitted and umbrella part X21 remains, an "eaves structure" that can further reduce the reflection can be imparted to wiring body 1A.

### (3.2) Second modification

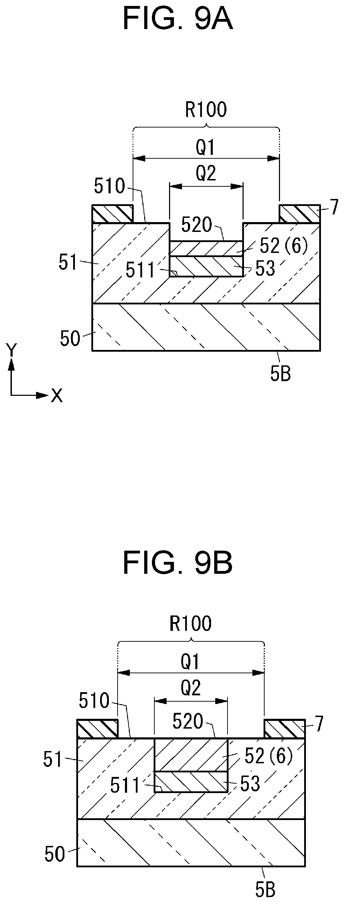

Wiring body 1B according to the present modification (second modification) will be described with reference to Figs. 9A to 10. Hereinafter, constituent elements substantially common to wiring body 1 of the first basic example are denoted by the same reference marks, and descriptions thereof may be appropriately omitted. In addition, regarding a manufacturing method as well, descriptions of processes (steps) substantially common to those of the manufacturing method of wiring body 1 of the first basic example may be appropriately omitted.

In the present modification, pattern plate 5B used for manufacturing wiring body 1B is different from pattern plate 5 used for manufacturing wiring body 1 of the first basic example. Specifically, as illustrated in Fig. 9A, pattern plate 5B is different from pattern plate 5 in that first width Q1 of region R100 in which resin layer 7 is not provided in the X-axis direction is wider than second width Q2 of recessed portion 511 in which parent material 52 is accommodated in adhesive layer 51. That is, first width Q1 and second width Q2 are substantially equal in the first basic example. Note that second width Q2 is substantially equal to a lateral width of parent material 52, and is also substantially equal to lateral width M1 of conductive layer X1 in the present modification. In other words, resin layer 7 is separated from catalyst 6 (parent material 52) by a predetermined distance in the X-axis direction in the present modification.

In addition, pattern plate 5B of the present modification has adhesion layer 53 (metal layer) in recessed portion 511. Parent material 52 is stacked on adhesion layer 53 in recessed portion 511. In short, parent material 52 and adhesion layer 53 are embedded in adhesive layer 51. Parent material 52 is stably held in recessed portion 511 by adhesion layer 53.

In addition, a thickness of resin layer 7 of the present modification is set to be larger than the thickness of resin layer 7 of the first basic example.

In the example of Fig. 9A, front surface 520 of parent material 52 (catalyst 6) is formed so as to be lower in the direction of approaching base material 50 than front surface 510 of adhesive layer 51, which is similar to the first modification. However, front surface 520 of parent material 52 may be substantially flush with front surface 510 of adhesive layer 51 as illustrated in Fig. 9B.

### [Manufacturing method of wiring body]

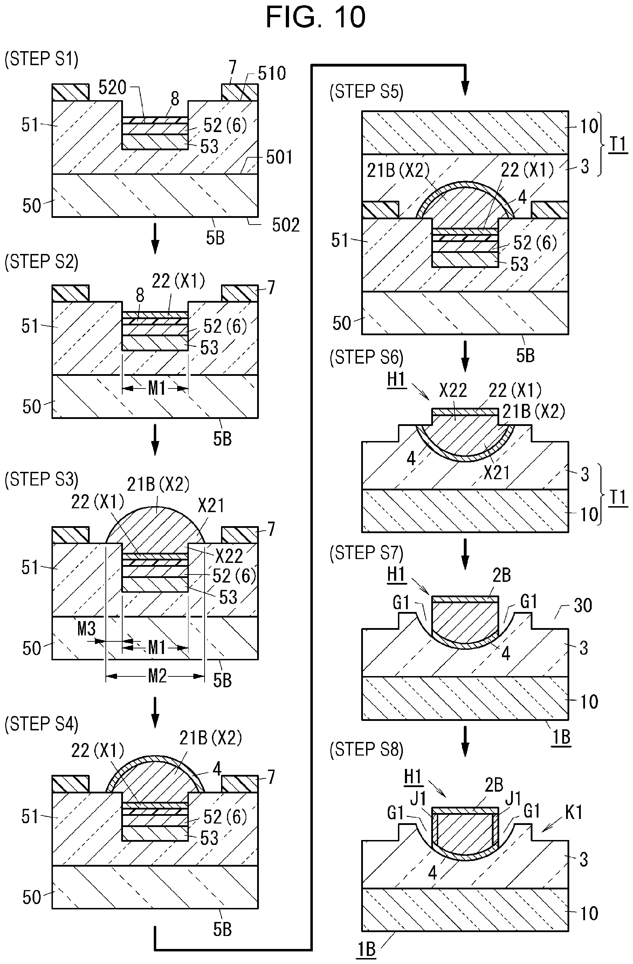

Next, a manufacturing method of wiring body 1B using pattern plate 5B in the present modification will be described with reference to Fig. 10.

The manufacturing method of wiring body 1B of the present modification includes steps S1 to S8. Wiring body 1B can be manufactured, for example, in the order of step S1 to step S8. However, the manufacture of wiring body 1B is not strictly limited to being executed in the order of steps S1 to S8.

Wiring body 1B of the present modification has a structure approximate to that of wiring body 1A of the first modification. That is, wiring body 1B also includes protruding structure HI depending on a size of conductive layer 21B (a height with respect to a bottom of accommodating part 31). Note that stepped part K1 is formed in insulator 3 in wiring body 1B, which is different from wiring body 1A. Hereinafter, conductive layer 22 may be referred to as "conductive layer X1". In addition, conductive layer 21B may be referred to as "specific layer X2".

Step S1 is the release process. In step S1, a release treatment is performed to form organic film 8 on parent material 52 (catalyst 6).

In step S2 (the first growth process), conductive layer X1 is grown on parent material 52 having ultrathin organic film 8 formed on the front surface thereof by electroless plating.

In step S3 (a second growth process), specific layer X2 (conductive layer 21B) is grown on conductive layer X1 by electroless plating, specifically, so as to cover conductive layer X1 and resin layer 7 in the vicinity of conductive layer X1. Specific layer X2 is formed so as to cover conductive layer X1. Specific layer X2 is formed so as to cover conductive layer X1. Specifically, specific layer X2 includes umbrella part X21 having a substantially semicircular cross section, and base X22 that is narrower than umbrella part X21 below umbrella part X21 and has a substantially rectangular cross section. Base X22 is buried in recessed portion 511.

Here, umbrella part X21 of specific layer X2 can be grown to fall within region R100 (see Fig. 9A) where resin layer 7 is not provided. In the first modification, umbrella part X21 is formed so as to partially overlap an upper surface at an edge part of resin layer 7, that is, so as to protrude from region R100, the present modification is different from the first modification in this regard.

Step S4 is the blackening process. In step S4, a part of a front surface (surface layer) of specific layer X2, formed in step S3, is oxidized to form a blackened layer (that is, adhesion layer 4) which is an oxide of copper (here, a copper oxide).

Step S5 is the transfer process. In step S5, transfer member T1 is pressure-bonded to pattern plate 5B subjected to step S4, thereby transferring conductive layer X1, specific layer X2, and adhesion layer 4 to transfer member T1.

Step S6 is the peeling process. In step S6, transfer member T1 is peeled off from pattern plate 5B. As a result, conductive layer X1, specific layer X2, and adhesion layer 4 are fixed to transfer member T1 in an integrated manner.

Step S7 is the removal process (etching process). In step S7, an etching treatment is performed on front surface 30 of insulator 3 to form grooves G1 on both sides of conductor 2B.

Regarding step S8, when step S4 is a first blackening process, step S8 is a second blackening process, which is similar to the first modification. In step S8, blackened layer J1 is formed on a side surface of conductive layer 21B.

Wiring body 1B of the present modification also has an advantage that adhesion can be improved by groove G1.

Furthermore, in pattern plate 5B, first width Q1 of region R100 where resin layer 7 is not provided is wider than second width Q2 of recessed portion 511 in which parent material 52 in adhesive layer 51 is accommodated in the present modification. That is, since resin layer 7 is separated from catalyst 6 (parent material 52) by a predetermined distance in the X-axis direction, a possibility that resin layer 7 hinders the growth in the growth process can be reduced. Thus, a plating solution in the growth process easily comes into contact with parent material 52 (catalyst 6). As a result, stable wiring growth becomes possible.

### [Second exemplary embodiment]

### (1) Outline

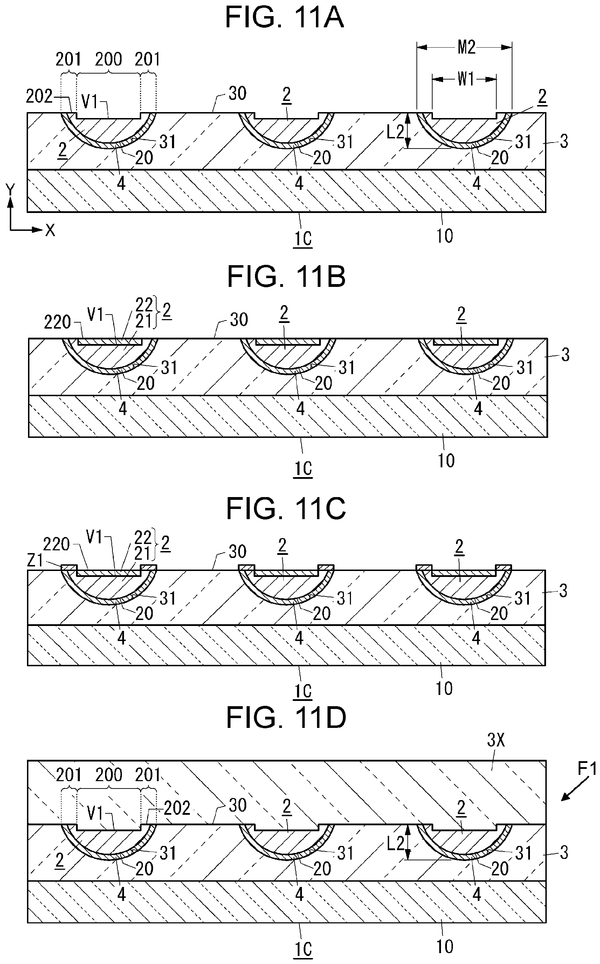

Hereinafter, wiring body 1C according to a second exemplary embodiment will be described with reference to Figs. 11A to 15B. Each of the drawings described in the following second exemplary embodiment is a schematic view, and the ratio of the size and the thickness of each constituent element in each drawing does not necessarily reflect the actual dimensional ratio. Note that constituent elements substantially common to those of the first exemplary embodiment are denoted by the same reference marks, and descriptions thereof may be appropriately omitted. In addition, regarding a manufacturing method as well, descriptions of processes (steps) substantially common to those of the manufacturing method according to the first exemplary embodiment may be appropriately omitted.

Wiring body 1C according to the present exemplary embodiment may also be applied to, for example, touch sensor A1 (see Figs. 1A and 1B) or mounting board B1 (see Fig. 6).

As illustrated in Fig. 11A, wiring body 1C according to the present exemplary embodiment includes conductor 2 and insulator 3. Conductor 2 is disposed so as to be at least partially (substantially entirely in the example of Fig. 11A) embedded in front surface 30 of insulator 3. Conductor 2 has recess VI in central part 200 of surface 202 on a side opposite to contact portion 20 in contact with insulator 3.

### (2) Details

### (2.1) Wiring body and manufacturing method thereof

Wiring body 1C and a manufacturing method thereof in the present exemplary embodiment will be described in detail with reference to Figs. 11A to 12. Numerical values (dimensions and the like) disclosed hereinafter are merely examples, and are not limited.

### [Structure of wiring body]

As illustrated in Fig. 11A, wiring body 1C includes a plurality of conductors 2 constituting sensor electrodes A2, insulator 3, and base material 10. Fig. 11A illustrates a sectional view of only a part of wiring body 1C, and particularly illustrates only three conductors 2 for convenience of the description. Each conductor 2 corresponds to one of the metal thin wires forming the plurality of regions R3 (see Fig. 1A in the first exemplary embodiment) having substantially rhombic shapes. Fig. 11A is a schematic sectional view of wiring body 1C taken along a plane orthogonal to the longitudinal direction of each conductor 2 (metal thin wire). In Fig. 11A, three conductors 2 are arranged in the lateral direction at substantially equal intervals.

Conductor 2 is a portion having conductivity. Conductor 2 has a substantially rectangular cross section that is elongated along the X-axis direction. That is, a thickness direction of conductor 2 extends along the Y-axis direction. Conductor 2 is disposed so as to be substantially entirely embedded in front surface 30 of insulator 3. That is, insulator 3 has accommodating part 31, configured to accommodate conductor 2, on front surface 30. Accommodating part 31 is formed to be recessed from front surface 30 so as to have a substantially semicircular cross section. A sectional area of accommodating part 31 is substantially equal to a sectional area of conductor 2.

Insulator 3 is a portion having an electrical insulation property. Insulator 3 is, for example, a resin layer. Insulator 3 is made of a light-transmissive resin or the like. The thickness direction of insulator 3 extends along the Y-axis direction. Here, contact portion 20 of conductor 2 with insulator 3 corresponds to an end surface (curved surface) in the negative direction of the Y axis. Contact portion 20 has a substantially arcuate cross section along an inner surface of accommodating part 31.

Base material 10 is a portion that supports conductor 2 and insulator 3. Base material 10 is a plate material having a light-transmitting property, and is made of, for example, glass, a light-transmissive resin, or the like. A thickness direction of base material 10 extends along the Y-axis direction. Insulator 3 is stacked on a front surface of base material 10 in the positive direction of the Y axis.

In addition, wiring body 1C of the present exemplary embodiment further includes adhesion layer 4 which has adhesion and is disposed at an interface between insulator 3 and conductor 2. Then, contact portion 20 is in contact with insulator 3 via adhesion layer 4.

Here, conductor 2 has recess VI in central part 200 of surface 202 on the side opposite to contact portion 20 in contact with insulator 3 as illustrated in Fig. 11A. Conductor 2 is made of copper or an alloy of copper nickel (CuNi). A thickness of conductor 2 is, for example, about 1 µm to 1.5 µm. Lateral width W1 (dimension in the X-axis direction) of recess VI is, for example, about 2 µm.

Meanwhile, conductor 2 of the present exemplary embodiment may have a two-layer structure as illustrated in Fig. 11B. Specifically, conductor 2 may include the conductive layer 21 having the contact portion 20 and recess VI, and the conductive layer 22 disposed in recess VI. Conductive layer 22 is stacked so as to be embedded in recess VI on a front surface of conductive layer 21 in the positive direction of the Y axis. Front surface 220 of conductive layer 22 in the positive direction of the Y axis is substantially flush with front surface 30 of insulator 3.

Conductive layer 21 in Fig. 11B corresponds to conductor 2 in Fig. 11A, and is made of copper or an alloy of copper nickel (CuNi). A thickness of conductive layer 21 is, for example, about 1 µm to 1.5 µm.

Conductive layer 22 is formed as a layer containing nickel and boron (for example, a NiB layer). A thickness of conductive layer 22 is, for example, about 0.3 µm. Therefore, conductive layer 22 is a layer different in material from conductive layer 21.

Conductor 2 preferably contains nickel. In the configuration of Fig. 11A, conductor 2 is preferably made of an alloy of copper nickel (CuNi). In the configuration of Fig. 11B, conductor 2 preferably contains nickel in at least one layer of conductive layer 21 and conductive layer 22. In this case, reliability (conductivity, corrosion resistance, and the like) of conductor 2 can be improved.

Here, adhesion layer 4 is an oxide of copper. Adhesion layer 4 is assumed to be, for example, copper oxide (CuO), but is not limited to copper oxide (CuO) as long as being an oxide of copper. In addition, adhesion layer 4 corresponds to a blackened layer. When a blackening treatment is performed on a part of the front surface (contact portion 20) of conductor 2 (conductive layer 21 in the case of Fig. 11B), the part becomes the blackened layer (adhesion layer 4).

Lateral width M2 (dimension in the X-axis direction) of conductor 2 is, for example, about 3 µm to 4 µm. Thickness L2 (dimension in the Y-axis direction) of conductor 2 including a thickness of adhesion layer 4 is, for example, about 1 µm to 2 µm.

In addition, in wiring body 1C illustrated in Fig. 11B, adhesion layer Z1 having adhesion may be formed on the front surface (surface on the side opposite to contact portion 20) of conductive layer 21 as illustrated in Fig. 11C. In other words, wiring body 1C may further include adhesion layer Z1 disposed so as to cover region 201 around central part 200 in conductor 2. Here, as an example, adhesion layer Z1 is an oxide of copper, which is similar to adhesion layer 4. Adhesion layer Z1 is assumed to be, for example, copper oxide (CuO), but is not limited to copper oxide (CuO) as long as being an oxide of copper. In addition, adhesion layer Z1 corresponds to a blackened layer.

In wiring body 1C, insulator 3X (a resin layer) different from insulator 3 may be formed on front surface 30 of insulator 3 to manufacture film body F1 as illustrated in Fig. 11D. Insulator 3X may be formed on front surface 30 of insulator 3 in wiring body 1C illustrated in Fig. 11B or 11C. Note that, when the above-described adhesion layer Z1 is provided, adhesion with insulator 3X can be improved when the above insulator 3X is formed in wiring body 1C.

In this manner, conductor 2 has recess VI in central part 200 in the present exemplary embodiment. Thus, there is a high possibility that light scattering occurs on an inner surface of recess VI. Therefore, a light quantity of light (reflected light) traveling straight to eyes of a person viewing wiring body 1C can be reduced. In particular, when central part 200 is not subjected to a blackening treatment, the reflected light can be suppressed. As a result, wiring body 1C according to the present exemplary embodiment has an advantage that it is possible to achieve improvement regarding the reflected light by conductor 2.

In addition, when conductor 2 has the two-layer structure as illustrated in Fig. 11B, it is easy to cause conductive layer 22 to function as a connection terminal configured to perform electrical connection with the outside (for example, an external terminal) while achieving the improvement regarding the reflected light by conductor 2.

### [Manufacturing method of wiring body]

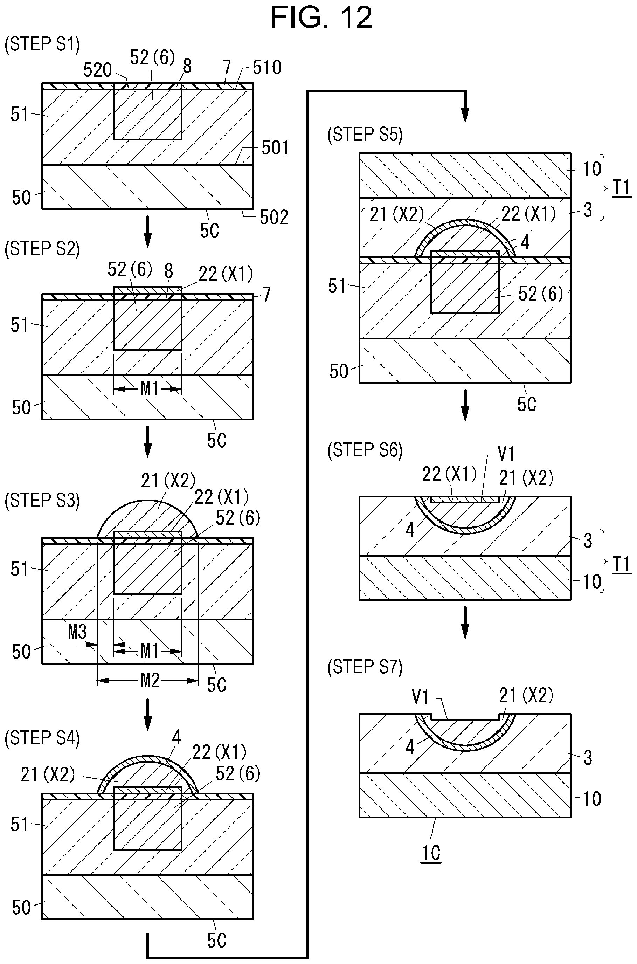

Next, a manufacturing method of wiring body 1C will be described with reference to Fig. 12.

As illustrated in Fig. 12, the manufacturing method of wiring body 1C includes steps S1 to S7. However, the number of steps is not limited to seven. The manufacturing method of wiring body 1C may further include other steps in addition to steps S1 to S7.

Wiring body 1C of the present exemplary embodiment can be manufactured, for example, in the order of steps S1 to S7. However, the manufacture of wiring body 1C is not strictly limited to being executed in the order of steps S1 to S7. In addition, a description regarding a finishing process and the like performed after step S7 is omitted here.

Although only one conductor 2 is illustrated in Fig. 12 since the description is given by paying attention to only one conductor 2, wiring body 1C including a plurality of conductors 2 can be formed through steps S1 to S7.

Here, wiring body 1C of the present exemplary embodiment is manufactured using pattern plate 5C. Hereinafter, a case where the two-layer structure (conductive layer 21 and conductive layer 22) illustrated in Fig. 11B is produced, and thereafter, conductive layer 22, for example, is partially removed will be described as an example. Hereinafter, conductive layer 22 may be referred to as "conductive layer X1". In addition, conductive layer 21 may be referred to as "specific layer X2".

The manufacturing method of wiring body 1C according to the present exemplary embodiment includes a growth process, a transfer process, and a peeling process. In the growth process, conductive layer X1 of wiring body 1C is grown on catalyst 6 provided on pattern plate 5C. In the transfer process, conductive layer X1 on pattern plate 5C is transferred to insulator 3. In the peeling process, conductive layer X1 is peeled off from pattern plate 5C together with insulator 3. When a plurality of wiring bodies 1 C are manufactured, the growth process, the transfer process, and the peeling process are repeatedly executed using the same pattern plate 5C. The manufacturing method of wiring body 1C according to the present exemplary embodiment further includes a release process, a blackening process, and a removal process (a process of partially removing a conductive layer), and these processes are also repeatedly executed together with the growth process, the transfer process, and the peeling process when the plurality of wiring bodies 1C are manufactured.

Hereinafter, the manufacturing method of wiring body 1C will be described in order from step S1 in Fig. 12.

Step S1 is the release process. In step S1, a release treatment is performed to form organic film 8 on parent material 52 (catalyst 6). When the release treatment is performed, conductive layer X1 (conductive layer 22) is easily removed from a mold, that is, peeled off from pattern plate 5C in the peeling process to be described later.

Step S2 is the growth process that is a process of growing conductive layer X1 (conductive layer 22) by electroless plating. In the present exemplary embodiment, the growth process further includes not only a first growth process of growing conductive layer X1 but also a second growth process of growing specific layer X2 (conductive layer 21) as another conductive layer on conductive layer X1. Step S2 corresponds to the first growth process, and the next step S3 corresponds to the second growth process of growing specific layer X2 by electroless plating.

In step S2 (the first growth process), conductive layer X1 is grown on parent material 52 having ultrathin organic film 8 formed on the front surface thereof by electroless plating. That is, pattern plate 5C is immersed in a plating solution in which a metal salt and a reducing agent coexist. Here, the electroless plating is performed by immersing pattern plate 5C, subjected to step S1 (the release process), in a plating solution containing nickel, for example, an electroless Ni-B plating solution, so that the metal containing nickel is precipitated to form conductive layer X1. That is, here, the plating solution may contain a boron compound as a reducing agent. As a result, conductive layer 22 (conductive layer X1) containing nickel and boron is formed as described above.

It is not essential for conductive layer 22 to contain boron, and the plating solution may be, for example, an electroless Ni-P plating solution or an electroless Cu-Ni (copper nickel) solution other than the electroless Ni-B plating solution.

Lateral width M1 of conductive layer X1 subjected to step S2 is substantially equal to a lateral width of parent material 52, and this is also substantially equal to lateral width W1 (about 2 µm) of recess VI of wiring body 1C illustrated in Fig. 11A.

In step S3 (the second growth process), specific layer X2 (conductive layer 21) is grown on conductive layer X1 by electroless plating, specifically, so as to cover conductive layer X1 and resin layer 7 in the vicinity of conductive layer X1. That is, in step S3 as well, pattern plate 5C is immersed in a plating solution in which a metal salt and a reducing agent coexist. Here, for example, pattern plate 5C, subjected to step S2 (the first growth process), is immersed in an electroless Cu-Ni (copper nickel) plating solution to perform electroless plating, so that metal (copper nickel) is precipitated to form specific layer X2 of copper nickel. Specific layer X2 is formed to have a substantially semicircular cross section so as to cover conductive layer X1. Here, conductive layer X1 is thinner than specific layer X2. For example, a thickness of specific layer X2 is about 1 µm to 1.5 µm, whereas a thickness of conductive layer X1 is about 0.3 µm.

Lateral width M2 of specific layer X2 subjected to step S3 is larger than lateral width M1 of conductive layer X1, and is, for example, about 3 µm to 4 µm. Note that distance M3 from an edge of conductive layer X1 to an edge of specific layer X2 is, for example, about 0.5 µm to 1 µm.

The plating solution in step S3 does not necessarily contain nickel, and may be an electroless Cu (copper) plating solution. In this case, specific layer X2 of copper is formed.

In the above example, conductive layer X1 and specific layer X2, which contain copper as metal having a relatively high conductivity, are formed, but conductive layer X1 and specific layer X2 may contain, for example, silver or gold instead of copper. In short, the plating solution is not limited to those described above.

Through the above growth process, conductive layer X1 can be stably formed. In particular, the two-layer structure can be stably achieved by the first growth process and the second growth process.

Step S4 is the blackening process. In step S4, a part of a front surface (surface layer) of specific layer X2, formed in step S3, is oxidized to form a blackened layer (that is, adhesion layer 4) which is an oxide of copper (here, a copper oxide). In other words, step S4 corresponds to a formation process of forming adhesion layer 4 having adhesion on a side of conductive layer X1 opposite to pattern plate 5C (here, on the front surface of specific layer X2 stacked on conductive layer X1). Adhesion layer 4 made of the copper oxide can be formed by, for example, immersing the surface layer of specific layer X2 in an appropriate oxidation treatment liquid to advance roughening of the front surface of specific layer X2. Adhesion layer 4 can be expected as a layer having a relatively high adhesion with respect to insulator 3 (the resin layer).

Note that the blackened layer (adhesion layer 4) is not limited to the copper oxide. The blackened layer may be formed by, for example, performing an etching treatment or the like on the surface layer of specific layer X2 to perform the roughening of the front surface, or may be formed by a plating treatment (for example, palladium substitution plating). Note that adhesion layer 4 is not an essential constituent element in the present disclosure. For example, if specific layer X2 itself is black, the blackened layer (adhesion layer 4) may be omitted. Since adhesion layer 4 is formed in this manner, conductive layer X1 is easily transferred to insulator 3 by adhesion layer 4 in the next transfer process. In addition, since the blackened layer (adhesion layer 4) is formed, it is possible to reduce the reflection in wiring body 1C. Note that the blackened layer (adhesion layer 4) may be partially removed in a subsequent process.

Step S5 is the transfer process. In step S5, transfer member T1 is pressure-bonded to pattern plate 5C subjected to step S4, thereby transferring conductive layer X1, specific layer X2, and adhesion layer 4 to transfer member T1. Transfer member T1 is a member which is to serve as base material 10 and insulator 3 of (the completed) wiring body 1C illustrated in Fig. 11A. Transfer member T1 is pressed against pattern plate 5C with a front surface (front surface 30) of a member corresponding to insulator 3 opposing pattern plate 5C. As a result, conductive layer X1, specific layer X2, and adhesion layer 4 are embedded in the member corresponding to insulator 3 of transfer member T1.

Step S6 is the peeling process. In step S6, transfer member T1 is peeled off from pattern plate 5C. As a result, conductive layer X1, specific layer X2, and adhesion layer 4 are fixed to transfer member T1 in an integrated manner. At this time, transfer member T1 can be easily peeled off from pattern plate 5C since pattern plate 5C is provided with resin layer 7 and organic film 8 having easy peelability as described above. In other words, excessive stress is hardly applied to transfer member T1 and pattern plate 5C, transfer member T1 can be substantially uniformly peeled off, and conductive layer X1, specific layer X2, and adhesion layer 4 can be prevented from partially remaining on pattern plate 5C.

In particular, since resin layer 7 is made of the fluorine-based resin, options of materials for insulator 3 of transfer member T1, adhesive layer 51 of pattern plate 5C, and the like can be increased when the peelability is considered.

Step S7 is a process of partially removing conductive layer X1. In step S7, a part or whole of conductive layer X1 in the longitudinal direction of conductor 2 is removed by appropriate means (for example, an etching treatment or the like). Conductive layer X1 may partially remain.

In this manner, wiring body 1C illustrated in Fig. 11A in the present exemplary embodiment is manufactured.

Meanwhile, a step of performing a blackening treatment separately from the blackening treatment in step S4 may be provided between step S6 and step S7. That is, the step for formation of adhesion layer Z1 (blackened layer: CuO) illustrated in Fig. 11C may be provided. Since conductive layer X1 (conductive layer 22) is a layer containing nickel and boron (for example, a NiB layer), conductive layer X1 is not blackened (CuO) even if the blackening treatment (CuO) is performed. That is, adhesion layer Z1 is formed so as to cover region 201 around central part 200 in conductor 2. Therefore, when adhesion layer Z1 (blackened layer) is formed, conductor 2 can be exposed in central part 200 where adhesion layer Z1 is not formed while further suppressing the deterioration in visibility. Thus, in a case where wiring body 1C constitutes wiring A3 of touch sensor A1, for example, a portion (conductive layer 22) exposed in central part 200 can function as a contact portion (connection terminal) that makes electrical contact with an input terminal of flexible wiring board F2.

### (3) Modifications

The above-described second exemplary embodiment is merely one of various exemplary embodiments of the present disclosure. The second exemplary embodiment can be variously changed in accordance with design and the like as long as the object of the present disclosure can be achieved. Hereinafter, modifications of the second exemplary embodiment will be listed. Hereinafter, the second exemplary embodiment may be referred to as a "second basic example". Each modification described hereinafter can be applied by being appropriately combined with the first basic example or the modifications thereof in the first exemplary embodiment, the second basic example, or another modification.

### (3.1) First modification

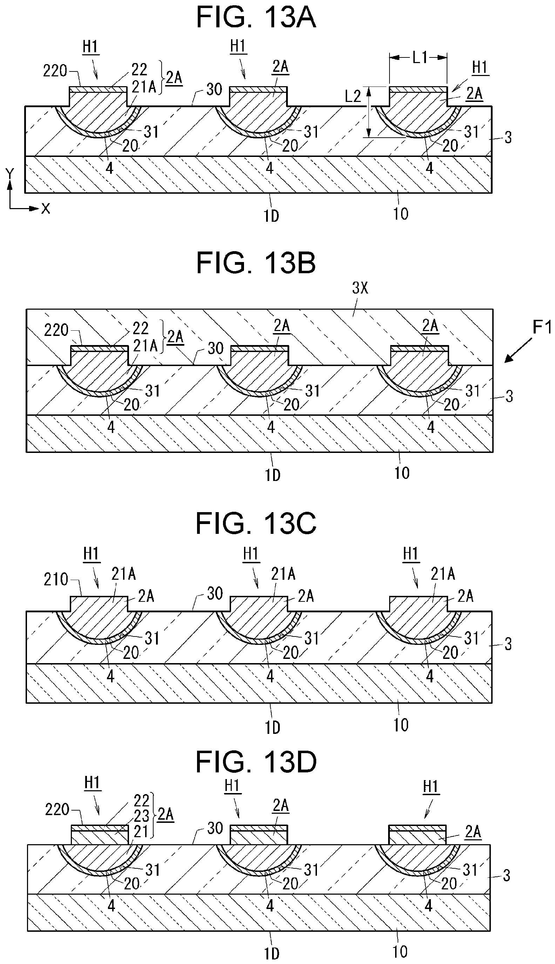

Wiring body 1D according to the present modification (first modification) will be described with reference to Figs. 13A to 14. Hereinafter, constituent elements substantially common to wiring body 1C of the second basic example are denoted by the same reference marks, and descriptions thereof may be appropriately omitted. In addition, regarding a manufacturing method as well, descriptions of processes (steps) substantially common to those of the manufacturing method of wiring body 1C of the second basic example may be appropriately omitted.

In wiring body 1C of the second basic example, the front surface of conductor 2 (front surface 220 of conductive layer 22) is substantially flush with front surface 30 of insulator 3 in the Y-axis direction. Wiring body 1D of the present modification is different from wiring body 1C of the second basic example in that a front surface of conductor 2A protrudes from front surface 30 of insulator 3 in the Y-axis direction.

### [Structure of wiring body]

As illustrated in Fig. 13A, wiring body 1D of the present modification includes conductor 2A including conductive layer 21A and conductive layer 22, insulator 3, and base material 10.

Here, wiring body 1D includes protruding structure HI protruding from front surface 30 in a direction away from contact portion 20 on a side of conductor 2A opposite to contact portion 20 as illustrated in Fig. 13A. Conductor 2A of the present modification has a larger dimension in the Y-axis direction than conductor 2 of wiring body 1C of the second basic example. That is, protruding structure HI depending on a size (height with respect to a bottom of accommodating part 31) of conductive layer 21A is formed. Therefore, thickness L2 (dimension in the Y-axis direction) of conductor 2A is larger than thickness L2 of conductor 2 of the second basic example.

In this configuration, electric resistance (wiring resistance) can be reduced according to the volume of protruding structure HI. As a result, for example, when wiring body 1D is applied to touch sensor A1, it is easy to increase a size of the touch sensor.

In particular, when insulator 3 and insulator 3X are combined as illustrated in Fig. 13B, there is a high possibility that the center of gravity of conductor 2 can be disposed at the midpoint of these resins since protruding structure HI is provided in this configuration. As a result, stress at the time of bending film body F1 is easily mitigated.

Note that conductor 2A is not limited to a two-layer structure, and conductor 2A may include only conductive layer 21A as illustrated in Fig. 13C. In this case, front surface 210 of conductive layer 21A protrudes from front surface 30 of insulator 3 in the Y-axis direction.

Meanwhile, conductor 2A may include conductive layer 21 having contact portion 20, conductive layer 22 disposed on a side of conductive layer 21 opposite to contact portion 20, and conductive layer 23 as illustrated in Fig. 13D. Conductive layer 23 is interposed between conductive layer 21 and conductive layer 22. Protruding structure HI is configured using conductive layer 23. In short, conductor 2A illustrated in Fig. 13D has a three-layer structure. In this case, conductive layer 23 contains copper and nickel. In this case, conductive layer 21 contains copper, but does not necessarily contain nickel, which is different from conductive layer 23. Conductive layer 22 is formed as a layer containing nickel and boron (for example, a NiB layer). In short, a material of conductive layer 23 is different from those of conductive layer 21 and conductive layer 22.

According to the configuration of conductor 2A illustrated in Fig. 13D, protruding structure HI is easily achieved. In addition, the electric resistance (wiring resistance) can be further reduced.

### [Manufacturing method of wiring body]

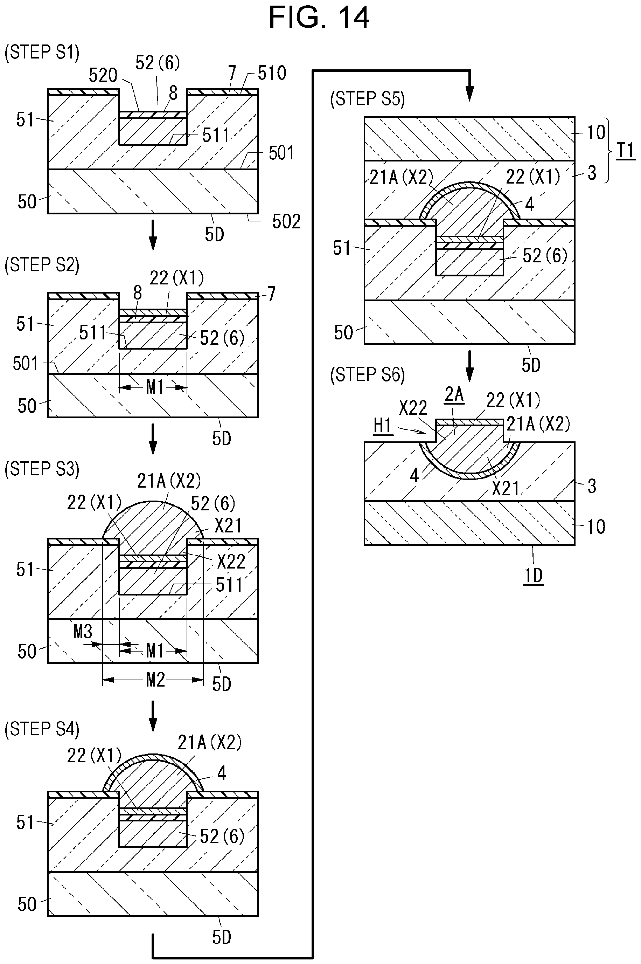

Next, a manufacturing method of wiring body 1D of the present modification will be described with reference to Fig. 14.

As illustrated in Fig. 14, the manufacturing method of wiring body 1D of the present modification includes steps S1 to S6. Wiring body 1D can be manufactured, for example, in the order of step S1 to step S6. However, the manufacture of wiring body 1D is not strictly limited to being executed in the order of steps S1 to S6.

Wiring body 1D of the present modification is manufactured using pattern plate 5D. Here, pattern plate 5D is formed such that front surface 520 of parent material 52 (catalyst 6) becomes lower in a direction of approaching base material 50 than front surface 510 of adhesive layer 51 in order to form protruding structure HI described above as compared with pattern plate 5C used in the manufacture of wiring body 1C of the second basic example. Note that a thickness of parent material 52 is set to be smaller than a thickness of parent material 52 (see Fig. 12) of the second basic example in the example of Fig. 14, but the thickness of parent material 52 may be set to be the same, and instead, a thickness of adhesive layer 51 and a depth of recessed portion 511 in which parent material 52 is accommodated may be increased.

In the present modification, organic film 8 formed on parent material 52 is also formed to be lower in the direction of approaching base material 50 than resin layer 7.

In short, pattern plate 5D has a recess structure to form protruding structure HI of wiring body 1D by setting front surface 520 of parent material 52 to a position lower than front surface 510 of adhesive layer 51. Therefore, pattern plate 5D can easily achieve the manufacture of wiring body 1D capable of reducing the electric resistance (wiring resistance).

The manufacturing method of wiring body 1D using the above pattern plate 5D will be described with reference to Fig. 14. Hereinafter, conductive layer 22 may be referred to as "conductive layer X1". In addition, conductive layer 21A may be referred to as "specific layer X2".

Step S1 is the release process. In step S1, a release treatment is performed to form organic film 8 on parent material 52 (catalyst 6).

In step S2 (the first growth process), conductive layer X1 is grown on parent material 52 having ultrathin organic film 8 formed on the front surface thereof by electroless plating.

In step S3 (a second growth process), specific layer X2 (conductive layer 21A) is grown on conductive layer X1 by electroless plating, specifically, so as to cover conductive layer X1 and resin layer 7 in the vicinity of conductive layer X1. Specific layer X2 is formed so as to cover conductive layer X1. Specifically, specific layer X2 includes umbrella part X21 having a substantially semicircular cross section, and base X22 that is narrower than umbrella part X21 below umbrella part X21 and has a substantially rectangular cross section. Umbrella part X21 is formed over resin layer 7 (so as to partially overlap an upper surface at an edge part of resin layer 7). Base X22 is buried in recessed portion 511.

Note that, when conductor 2A having the three-layer structure illustrated in Fig. 13D is manufactured, it is preferable to provide a step (third growth process) of growing conductive layer 23 by electroless plating between step S2 and step S3.

Step S4 is the blackening process. In step S4, a part of a front surface (surface layer) of specific layer X2, formed in step S3, is oxidized to form a blackened layer (that is, adhesion layer 4) which is an oxide of copper (here, a copper oxide).

Step S5 is the transfer process. In step S5, transfer member T1 is pressure-bonded to pattern plate 5D subjected to step S4, thereby transferring conductive layer X1, specific layer X2, and adhesion layer 4 to transfer member T1.

Step S6 is the peeling process. In step S6, transfer member T1 is peeled off from pattern plate 5D. As a result, conductive layer X1, specific layer X2, and adhesion layer 4 are fixed to transfer member T1 in an integrated manner. Umbrella part X21 of specific layer X2 is embedded in insulator 3. On the other hand, base X22 protrudes from front surface 30 of insulator 3 as a portion constituting a part of protruding structure HI. A lateral width of base X22 (substantially equal to lateral width M1 of conductive layer X1) is narrower than a lateral width of umbrella part X21 (corresponding to lateral width M2 of specific layer X2).

Thereafter, a step of further performing a blackening treatment (forming adhesion layer Z1) for blackening the front surface of conductor 2A may be provided as in the second basic example. Since conductive layer 22 is a layer containing nickel and boron (for example, a NiB layer) as described above, conductive layer 22 is hardly blackened even if the blackening treatment (CuO) is performed. Therefore, in a case where a surface layer of conductive layer 22 is also subjected to blackening, for example, the surface layer of conductor 2A is immersed in an appropriate oxidation treatment solution after a nickel etching treatment is performed. In addition, the blackened layer (adhesion layer Z1) may be partially removed in a subsequent step. For example, in a case where wiring body 1D constitutes wiring A3 of touch sensor A1, the blackened layer may be removed for the contact portion to cause a part of conductor 2 to function as a connection terminal in order to enhance reliability related to electrical contact with the input terminal of flexible wiring board F2.

Meanwhile, in the present modification, umbrella part X21 of specific layer X2 is embedded in insulator 3. On the other hand, base X22 protrudes from front surface 30 of insulator 3 as a portion constituting a part of protruding structure HI. Another insulator 3X may be formed on wiring body 1D in a state where conductor 2 includes umbrella part X21 and base X22, or application to film body F1 or the like of touch sensor A1 may be performed. In short, recess V1 described in the second basic example is not an essential structure in wiring body 1D having the configuration in which conductor 2 includes umbrella part X21 and base X22 narrower than umbrella part X21. In this case, the blackened layer (adhesion layer 4) formed on a front surface of umbrella part X21 can cover the reflection of conductor 2 in a wider range, and the visibility is further improved. That is, the formation of umbrella part X21 can impart wiring body 1D with an "eaves structure" that can further reduce the reflection.

### (3.2) Other modifications

The point that groove G1 is formed in the first basic example has been described. Wiring body 1C in the second basic example may also be subjected to an etching treatment to include grooves G1, for example, as illustrated in Fig. 15A. That is, insulator 3 may have groove G1 recessed from front surface 30 around contact portion 20 of conductor 2. In this case, when another insulator 3X is formed on wiring body 1C, adhesion with insulator 3X can be improved. In this case, a bottom surface of recess VI substantially becomes a front surface of conductor 2. Conductor 2 may include a region where recess VI remains and a region where groove G1 is partially formed in its longitudinal direction.

In addition, the point that protruding structure HI is provided in the first modification of the second basic example has been described. As illustrated in Fig. 15B, for example, wiring body 1C in the second basic example may also have protruding structure HI protruding from front surface 30 in a direction away from contact portion 20 on a side of conductor 2 opposite to contact portion 20. In this case, recess VI is provided on an end surface of protruding structure HI. In this configuration as well, electric resistance (wiring resistance) can be reduced according to the volume of protruding structure HI. Conductive layer 22 may also be embedded in recess VI.

### (4) Summary

As described above, a manufacturing method according to a first aspect includes: a process of growing conductive layer X1 of wiring body 1 (1A to 1D) on catalyst 6 provided on pattern plate 5 (5A to 5D); a process of transferring conductive layer X1 on pattern plate 5 (5A to 5D) to insulator 3; and a process of peeling conductive layer X1 from pattern plate 5 together with insulator 3. The manufacturing method further includes: a process of growing another conductive layer X1 of wiring body 1 (1A to 1D), different from the above-described wiring body 1 (1A to 1D), on catalyst 6 provided on the same pattern plate 5; a process of transferring the other conductive layer X1 on pattern plate 5 to another insulator 3 different from the above-described insulator 3; and a process of peeling the other conductive layer X1 from pattern plate 5 together with the other insulator 3.

According to the first aspect, it is possible to stabilize the quality of wiring body 1 (1A to 1D).

In the manufacturing method according to a second aspect, conductive layer X1 is grown by electroless plating.

The manufacturing method according to a third aspect further includes a process of growing specific layer X2 (conductive layer 22) on conductive layer X1 (conductive layer 21), and specific layer X2 is a layer having conductivity.

According to the third aspect, a two-layer structure can be stably achieved.

In the manufacturing method according to a fourth aspect, conductive layer X1 is thinner than specific layer X2.

According to the fourth aspect, a two-layer structure can be formed more stably.

The manufacturing method according to a fifth aspect includes a process of removing a part of specific layer X2.

According to the fifth aspect, groove G1 can be formed around specific layer X2, and, when another insulator 3X (for example, a resin layer) is formed on wiring body 1 (1A to 1D), adhesion with insulator 3X can be improved.

The manufacturing method according to a sixth aspect includes a process of removing a part of conductive layer X1.

According to the sixth aspect, groove G1 can be formed around conductive layer X1, and, when another insulator 3X (for example, a resin layer) is formed on the wiring body (1, 1A to 1D), the adhesion with insulator 3X can be improved.

In the manufacturing method according to a seventh aspect, etching removal is performed by aeration of an etching solution in the process of removing a part of specific layer X2 or the process of removing a part of conductive layer X1.

According to the seventh aspect, the progress by the etching removal can be easily controlled.

The manufacturing method according to an eighth aspect includes a process of forming adhesion layer 4 having adhesion above conductive layer X1.

According to the eighth aspect, conductive layer X1 is easily transferred to insulator 3 by adhesion layer 4 in the transferring process.

In the manufacturing method according to a ninth aspect, pattern plate 5 (5A to 5D) has resin layer 7 having easy peelability on an upper surface other than a region where catalyst 6 is provided.

According to the ninth aspect, insulator 3 or conductive layer X1 is easily peeled off from pattern plate 5 (5A to 5D).

In the production method according to a tenth aspect, resin layer 7 is made of a fluorine-based resin.

According to the tenth aspect, the peelability of resin layer 7 can be further improved.

In the manufacturing method according to an eleventh aspect, resin layer 7 is separated from catalyst 6.

According to the eleventh aspect, a possibility that resin layer 7 hinders the growth of wiring body 1 (1A to 1D) can be reduced.

In the manufacturing method according to a twelfth aspect, pattern plate 5 (5A to 5D) has organic film 8 having easy peelability on catalyst 6.

According to the twelfth aspect, insulator 3 or conductive layer X1 is easily peeled off from pattern plate 5 (5A to 5D).

Pattern plate 5 (5A to 5D) according to a thirteenth aspect is applied to the manufacturing method according to any one of the first to twelfth aspects.

According to the thirteenth aspect, it is possible to provide pattern plate 5 (5A to 5D) capable of stabilizing the quality of wiring body 1 (1A to 1D).

Note that the configurations according to the second to twelfth aspects are not essential configurations for the manufacturing method of wiring body (1, 1A to 1D), but can be omitted as appropriate.

Wiring body 1 (1A, 1B, 1C) according to a fourteenth aspect includes: insulator 3 including accommodating part 31 (recess); and conductor 2 (2A, 2B) at least a part of which is disposed in accommodating part 31 (recess), and wiring body 1 (1A, 1B, 1C) is provided with a gap between a side surface of conductor 2 (2A, 2B) and accommodating part 31 (recess) of insulator 3.

According to the fourteenth aspect, it is possible to improve the adhesion.

Wiring body 1 (1A, 1B, 1C) according to a fifteenth aspect further includes adhesion layer 4 that has adhesion and is located between accommodating part 31 (recess) of insulator 3 and a lower surface of conductor 2 (2A, 2B). Conductor 2 (2A, 2B) is in contact with insulator 3 via adhesion layer 4.

According to the fifteenth aspect, it is possible to improve adhesion inside wiring body 1 (1A, 1B, 1C) as well.

In wiring body 1 (1A, 1B) according to a sixteenth aspect, conductor 2 (2A, 2B) includes conductive layer 21 and conductive layer 22 stacked on conductive layer 21.

According to the sixteenth aspect, conductor 2 (2A, 2B) has a two-layer structure, it is easy to achieve two or more characteristics (for example, easy peelability and suitability for a blackening treatment). In addition, the two-layer structure enables selective etching.

In wiring body 1A (1B) according to a seventeenth aspect, an upper surface of conductor 2 (2B) is located above an upper surface of insulator 3. That is, conductor 2 (2B) protrudes from the upper surface of insulator 3. According to the seventeenth aspect, this configuration enables a reduction in electric resistance (wiring resistance) of conductor 2 (2B). As a result, for example, when wiring body 1A (1B) is applied to a touch sensor, it is easy to increase a size of the touch sensor.

### REFERENCE MARKS IN THE DRAWINGS

1, 1A to 1D: wiring body
2, 2A, 2B: conductor
20: contact portion
21, 21A, 21B, 22, 23: conductive layer
220: front surface
3, 3X: insulator
30: front surface
31: accommodating part (recess)
4: adhesion layer
5, 5A to 5D: pattern plate
51: adhesive layer
52: parent material
53: adhesion layer
501: first surface
502: second surface
6: catalyst
7: resin layer
8: organic film
A1: touch sensor
A2: sensor electrode
A3: wiring
F1: film body
F2: flexible wiring board
G1: groove
R1: sensor region
R2: wiring region
R3: region
U1: operating body
X1: conductive layer
X2: specific layer
Z1: adhesion layer

## Claims

1. A manufacturing method of a wiring body, the manufacturing method comprising:
a process of growing a first conductive layer of a first wiring body on a catalyst provided on a pattern plate;
a process of transferring the first conductive layer on the pattern plate to a first insulator;
a process of peeling the first conductive layer from the pattern plate together with the first insulator;
a process of growing a second conductive layer of a second wiring body on the catalyst provided on the pattern plate;
a process of transferring the second conductive layer on the pattern plate to a second insulator; and
a process of peeling the second conductive layer from the pattern plate together with the second insulator.

2. The manufacturing method according to Claim 1, wherein the first conductive layer and the second conductive layer are grown by electroless plating.

3. The manufacturing method according to Claim 1 or 2, further comprising a process of growing a specific layer on the first conductive layer,
wherein the specific layer is a layer having conductivity.

4. The manufacturing method according to Claim 3, wherein the first conductive layer is thinner than the specific layer.

5. The manufacturing method according to Claim 3 or 4, further comprising a process of removing a part of the specific layer.

6. The manufacturing method according to any one of Claims 1 to 5, further comprising a process of removing a part of the first conductive layer.

7. The manufacturing method according to Claim 5 or 6, wherein, in the process of removing a part of the specific layer or the process of removing a part of the first conductive layer, etching removal is performed by aeration of an etching solution.

8. The manufacturing method according to any one of Claims 1 to 7, further comprising a process of forming an adhesion layer having adhesion above the first conductive layer.

9. The manufacturing method according to any one of Claims 1 to 8, wherein the pattern plate has a resin layer having easy peelability on an upper surface other than a region where the catalyst is provided.

10. The manufacturing method according to Claim 9, wherein the resin layer is made of a fluorine-based resin.

11. The manufacturing method according to Claim 9 or 10, wherein the resin layer is separated from the catalyst.

12. The manufacturing method according to any one of Claims 1 to 11, wherein the pattern plate further includes an organic film having easy peelability on the catalyst.

13. A pattern plate that is applied to the manufacturing method according to any one of Claims 1 to 12.

14. A wiring body comprising:
an insulator having a recess; and
a conductor having at least a part being disposed in the recess,
the wiring body being provided with a gap between a side surface of the conductor and the recess of the insulator.

15. The wiring body according to claim 14, further comprising an adhesion layer that has adhesion and is located between the recess of the insulator and a lower surface of the conductor,
wherein the conductor is in contact with the insulator via the adhesion layer.

16. The wiring body according to Claim 14 or 15, wherein the conductor includes a first conductive layer and a second conductive layer stacked on the first conductive layer.

17. The wiring body according to any one of Claims 14 to 16, wherein the conductor has an upper surface located above an upper surface of the insulator.
